# EUROPEAN PATENT APPLICATION

(11) **EP 4 752 584 A1**
(43) Date of publication of application: **03.06.2026**
(21) Application number: 25218998.0
(22) Date of filing: 27.11.2025
(51) Int. Cl.: G01R 33/36, G01R 33/28

(54) **MAGNETIC RESONANCE IMAGING METHODS, MAGNETIC RESONANCE IMAGING DEVICES, AND ANTI-INTERFERENCE DEVICES**

(30) Priority: 27.11.2024 CN 202411721955
(71) Applicant: Shanghai United Imaging Healthcare Co., Ltd., Shanghai 201807 (CN)
(72) Inventor: WANG, Dongming, Shanghai, 201807 (CN); XIONG, Kun, Shanghai, 201807 (CN); HOU, Fangyan, Shanghai, 201807 (CN); LIU, Zimeng, Shanghai, 201807 (CN); XIE, Yu, Shanghai, 201807 (CN); HE, Zenan, Shanghai, 201807 (CN); LIU, Bin, Shanghai, 201807 (CN); XU, Boshuo, Shanghai, 201807 (CN); ZHANG, Rui, Shanghai, 201807 (CN)
(74) Representative: Wang, Bo

(57) **Abstract**

Embodiments of the present disclosure provide a magnetic resonance imaging (MRI) method, an MRI device, and an anti-interference device. The MRI method is implemented by the MRI device, and the MRI method includes: adjusting an operating frequency of at least one electronic device located inside a scanning room or entering into the scanning room, an adjusted frequency of the electronic device is outside an operating frequency of a magnetic resonance imaging device.

## Description

### CROSS-REFERENCE TO RELATED APPLICATIONS

This application claims priority to the Chinese Patent Application No. 202411721955.6, filed on November 27, 2024, the contents of which are hereby incorporated by reference.

### TECHNICAL FIELD

The present disclosure generally relates to a field of magnetic resonance (MR) technology, and in particular to a magnetic resonance imaging (MRI) method, a magnetic resonance imaging device, and an anti-interference device.

### BACKGROUND

With the rapid development of medical technology and biomedical engineering, a plurality of electronic devices (e.g., a heart rate monitor, a respiration monitor, a blood oxygen saturation monitor, a temperature control device, a lighting adjustment device, etc.) are increasingly used within the magnetic resonance imaging (MRI) scanning room to support more complex and accurate diagnosis and treatment processes. However, the electronic devices generate specific electromagnetic waves during operation. The frequency range of the specific electromagnetic waves may overlap with the operating frequency of the MRI system. Since the operating principle of the MRI system relies on precisely controlled radio frequency pulses and magnetic field gradients, any external electromagnetic interference can cause degradation of image quality, reduction of signal-to-noise ratio, or even errors in data acquisition, which severely affects final diagnosis results

Therefore, it is desired to provide MRI methods and devices that allow electronic devices to operate normally within the MRI scanning room without negatively affecting the performance of the MRI system.

### SUMMARY

One or more embodiments of the present disclosure provide a magnetic resonance imaging (MRI) method. The method is implemented by a magnetic resonance imaging device. The method includes: adjusting an operating frequency of at least one electronic device located inside a scanning room or entering into the scanning room, an adjusted frequency of the electronic device is outside an operating frequency of the magnetic resonance imaging device.

In some embodiments, the adjusting the operating frequency of the electronic device located inside the scanning room or entering into the scanning room includes: synchronizing a clock of the electronic device with a clock of the magnetic resonance imaging device, and the synchronizing the clock of the electronic device with the clock of the magnetic resonance imaging device includes at least one of: the magnetic resonance imaging device and the electronic device being connected via a cable;; or wireless clock signals being transmitted to the electronic device via wireless clock broadcasting.

In some embodiments, when there is the plurality of electronic devices, the transmitting the wireless clock signals to the electronic device via wireless clock broadcasting includes: transmitting the wireless clock signals to each of the plurality of electronic devices separately and unidirectionally in a one-to-many manner via the wireless clock broadcasting.

In some embodiments, the wireless clock signals are configured to synchronize a first clock frequency of the electronic device with a second clock frequency of the magnetic resonance imaging device.

In some embodiments, the wireless clock signals are configured that a first clock phase of the electronic device does not synchronize with a second clock phase of the magnetic resonance imaging device.

In some embodiments, the wireless clock signals are transmitted through a carrier, the carrier including at least one of infrared light, electromagnetic waves, or ultrasonic waves.

In some embodiments, when there is the plurality of electronic devices, the synchronizing the clock of the electronic device with the clock of the magnetic resonance imaging device includes: the magnetic resonance imaging device being connected to a first electronic device of the plurality of electronic devices via a cable, and the wireless clock signals being transmitted to a second electronic device of the plurality of electronic devices via the wireless clock broadcasting.

In some embodiments, the wireless clock signals are transmitted via the infrared light, and the synchronizing the clock of the electronic device with the clock of the magnetic resonance imaging device including: broadcasting, by the magnetic resonance imaging device, the infrared light carrying standard clock signals in the scanning room.

In some embodiments, the wireless clock signals are transmitted via the electromagnetic waves, and the synchronizing the clock of the electronic device with the clock of the magnetic resonance imaging device including: broadcasting, by the magnetic resonance imaging device, the infrared light carrying standard clock signals in the scanning room.

In some embodiments, the wireless clock signals are transmitted via the ultrasonic waves, and the synchronizing the clock of the electronic device with the clock of the magnetic resonance imaging device including: broadcasting, by the magnetic resonance imaging device, the ultrasonic waves carrying standard clock signals in the scanning room.

One or more embodiments of the present disclosure provide another magnetic resonance imaging (MRI) method. The method is implemented by a magnetic resonance imaging device. The method includes: synchronizing a clock of at least one electronic device located inside the scanning room and/or entering the scanning room with a clock of the magnetic resonance imaging device via wireless clock broadcasting.

In some embodiments, when there is the plurality of electronic devices, the synchronizing the clock of the electronic device located inside the scanning room and/or entering into the scanning room with the clock of the magnetic resonance imaging device via the wireless clock broadcasting includes: transmitting wireless clock signals to each of the plurality of electronic devices separately and unidirectionally in a one-to-many manner via the wireless clock broadcasting.

In some embodiments, the wireless clock signals are configured to synchronize a first clock frequency of the each electronic device with a second clock frequency of the magnetic resonance imaging device.

In some embodiments, the wireless clock signals are configured that a first clock phase of the each electronic device does not synchronize with a second clock phase of the magnetic resonance imaging device.

In some embodiments, the synchronizing the clock of the electronic device with the clock of the magnetic resonance imaging device includes: connecting the magnetic resonance imaging device to a first electronic device of the plurality of electronic devices by a cable, and transmitting the wireless clock signals to a second electronic device of the plurality of electronic devices via the wireless clock broadcasting.

In some embodiments, the synchronizing the clock of electronic device with the clock of the magnetic resonance imaging device includes at least one of the following: broadcasting, by the magnetic resonance imaging device, infrared light carrying standard clock signals in the scanning room; broadcasting, by the magnetic resonance imaging device, electromagnetic waves carrying the standard clock signals in the scanning room; or broadcasting, by the magnetic resonance imaging device, ultrasonic waves carrying the standard clock signals in the scanning room.

One or more embodiments of the present disclosure provide a magnetic resonance imaging (MRI) device. The magnetic resonance imaging (MRI) device is configured to: adjusting an operating frequency of at least one electronic device located inside a scanning room or entering into the scanning room, an adjusted frequency of the electronic device is outside an operating frequency of the magnetic resonance imaging device; or synchronizing a clock of an electronic device located inside the scanning room and/or entering into the scanning room with a clock of the magnetic resonance imaging device.

In some embodiments, the adjusting the operating frequency of the electronic device includes synchronizing the clock of the electronic device with the clock of the magnetic resonance imaging device, and the magnetic resonance imaging device includes a wireless clock broadcast module, the wireless clock broadcast module is configured to transmit wireless clock signals to the electronic device via wireless clock broadcast; the wireless clock broadcast module includes a standard clock source, a power amplifier, and a wireless transmitter; the standard clock source is configured to generate standard clock signals; the power amplifier is configured to amplify the standard clock signals and transmit the amplified standard clock signals to the wireless transmitter; and the wireless transmitter is configured to convert amplified standard clock signals into the wireless clock signals.

In some embodiments, the electronic device includes a wireless clock receiving module, and the wireless clock receiving module including a wireless receiver and a signal amplifier; the wireless receiver is configured to receive the wireless clock signals and perform a signal conversion to obtain converted signals; the signal amplifier is configured to amplify the converted signals.

In some embodiments, the electronic device includes a first electronic device associated with magnetic resonance scanning, the first electronic device including at least one of a wireless coil, a scanning bed, a power transmitting module, a signal receiving module, or a safety monitoring module; or the electronic device includes a second electronic device unrelated to the magnetic resonance scanning, the second electronic device including at least one of a monitoring module for a subject, a sensing module for the subject, a hyperbaric injection module, a physiological monitoring module, a subject care module, an environmental monitoring module, a mobile controller carried by a caregiver and/or a physician, a computer carried by a caregiver and/or a physician, or a cell phone carried by a caregiver and/or a physician.

One or more embodiments of the present disclosure provide an anti-interference device. The anti-interference device is removably mounted on an electronic device located inside a scanning room and/or entering the scanning room. The anti-interference device is configured to: adjusting an operating frequency of at least one electronic device located inside a scanning room or entering into the scanning room ,an adjusted frequency of the electronic device is outside an operating frequency of a magnetic resonance imaging device; or synchronizing a clock of an electronic device located inside the scanning room and/or entering into the scanning room with a clock of the magnetic resonance imaging device.

In some embodiments, the anti-interference device includes a wireless clock receiving module, the wireless clock receiving module including a wireless receiver and a signal amplifier; the wireless receiver is configured to receive wireless clock signals within the scanning room and perform a signal conversion to obtain converted signals; the signal amplifier is configured to amplify the converted signals.

In some embodiments, the adjusting the operating frequency of the electronic device includes synchronizing the clock of the electronic device with the clock of the magnetic resonance imaging device, and the magnetic resonance imaging device includes a wireless clock broadcast module, the wireless clock broadcast module is configured to transmit the wireless clock signals to the anti-interference device via wireless clock broadcast; the wireless clock broadcast module includes a standard clock source, a power amplifier, and a wireless transmitter; the standard clock source is configured to generate standard clock signals; the power amplifier is configured to amplify the standard clock signals and transmit the amplified standard clock signals to the wireless transmitter; and the wireless transmitter is configured to convert the amplified standard clock signals into the wireless clock signals.

In some embodiments, the electronic device includes a first electronic device associated with magnetic resonance scanning, the first electronic device including at least one of a wireless coil, a scanning bed, a power transmitting module, a signal receiving module, or a safety monitoring module ; or the electronic device includes a second electronic device unrelated to the magnetic resonance scanning, the second electronic device including at least one of a monitoring module for a subject, a sensing module for the subject, a hyperbaric injection module, a physiological monitoring module, a subject care module, an environmental monitoring module, a mobile controller carried by a caregiver and/or a physician, a computer carried by a caregiver and/or a physician, or a cell phone carried by a caregiver and/or a physician.

### BRIEF DESCRIPTION OF THE DRAWINGS

The present disclosure will be further described by way of exemplary embodiments. These exemplary embodiments will be described in detail with reference to the accompanying drawings. These embodiments are not limiting. In these embodiments, the same reference numerals refer to the same structures, wherein:
FIG. 1A is a schematic diagram illustrating of an application scenario of a magnetic resonance imaging (MRI) device according to some embodiments of the present disclosure;
FIG. 1B is a schematic diagram illustrating of an exemplary magnetic resonance imaging (MRI) method according to some embodiments of the present disclosure.
FIG. 2 is a schematic diagram illustrating of an exemplary wired clock synchronization link according to some embodiments of the present disclosure.
FIG. 3 is a schematic diagram illustrating of an exemplary wireless clock broadcast module according to some embodiments of the present disclosure.
FIG. 4 is a schematic diagram illustrating of an exemplary wireless clock receiving module according to some embodiments of the present disclosure.
FIG. 5 is a schematic diagram illustrating of an exemplary wireless clock broadcast synchronization link according to some embodiments of the present disclosure.
FIG. 6 is a schematic diagram illustrating of an exemplary wireless clock broadcast synchronization link according to some other embodiments of the present disclosure.
FIG. 7 is a schematic diagram illustrating of an exemplary wireless clock broadcast synchronization link according to some other embodiments of the present disclosure.
FIG. 8 is a schematic diagram illustrating of an exemplary wireless clock broadcast synchronization link according to some other embodiments of the present disclosure.
FIG. 9 is a schematic diagram illustrating of an exemplary magnetic resonance imaging (MRI) method according to some other embodiments of the present disclosure.
FIG. 10 is a flowchart of an exemplary process for wireless clock synchronization according to some embodiments of the present disclosure.
FIG. 11 is a schematic diagram illustrating of an exemplary clock signal according to some embodiments of the present disclosure.

### DETAILED DESCRIPTION

To more clearly illustrate the technical solutions in the embodiments of the present disclosure, the accompanying drawings required for describing the embodiments are briefly described below. Obviously, the accompanying drawings in the following description are merely some examples or embodiments of the present disclosure. For a person of ordinary skill in the art, the present disclosure may be applied to other similar scenarios based on these accompanying drawings without making creative efforts. Unless obvious from the context or otherwise indicated by the context, the same reference numerals in the drawings refer to the same structures or operations.

It should be understood that the terms "system", "device", "unit", and/or "module" used herein are a method for distinguishing components, elements, parts, portions, or assemblies of different levels. However, if other terms can achieve the same purpose, the aforementioned terms may be replaced by other expressions.

As used in the present disclosure and the claims, unless the context clearly indicates an exception, the terms "a", "an", "one", and/or "the" are not limited to the singular form and may include the plural form. Generally, the terms "include" and "comprise" merely indicate that the identified steps and elements are included. These steps and elements do not constitute an exclusive list, and a method or device may also include other steps or elements.

Flowcharts are used in the present disclosure to illustrate operations performed by systems according to the embodiments of the present disclosure. It should be understood that the preceding or following operations are not necessarily performed in exact sequence. On the contrary, the steps may be processed in reverse order or simultaneously. Meanwhile, other operations may be added to these processes, or one or more steps may be removed from these processes.

Magnetic resonance imaging (MRI) technology uses a high-intensity magnetic field and radio frequency(RF) pulses to obtain images of internal structures of a human body. In MRI device, nuclei have a specific Larmor precession frequency under a specific magnetic field. Signals are collected by modulating gradient magnetic fields and RF signals, and the collected signals are distributed within a specific frequency bandwidth. To maintain image quality, the MRI device is sensitive to noise within the specific frequency bandwidth. Electronic devices are usually restricted from entering a MRI scanning room to eliminate external interference.

Some embodiments of the present disclosure provide a MRI method and system. By adjusting an operating frequency of at least one electronic device located inside the scanning room and/or entering the scanning room, an adjusted frequency of the electronic device is outside the operating frequency of the MRI device. This ensures that the electronic device can operate normally in the MRI scanning room without causing interference to the MRI device. Furthermore, the operating frequency of the electronic device may be adjusted by synchronizing a clock of the MRI device with a clock of the electronic device, which enables efficient and reliable frequency adjustment. The operating frequency of the electronic device refers to the clock frequency used by the electronic device during normal operation when the electronic device is entering or located inside the MRI scanning room. The operating frequency of a magnetic resonance imaging apparatus refers to an operational frequency range of radiofrequency (RF) pulses and magnetic field gradients employed by the MRI apparatus when performing scanning and imaging tasks.

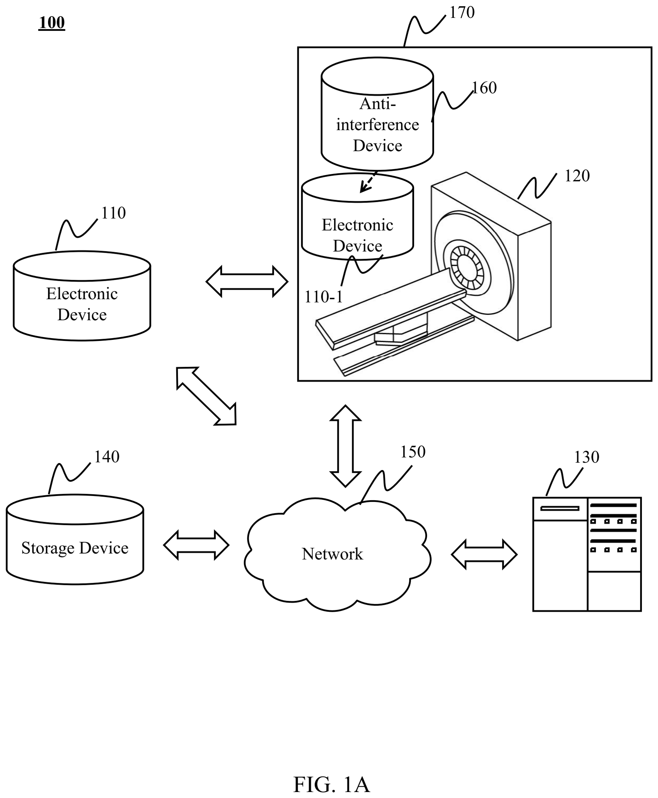

FIG. 1A is a schematic diagram illustrating of an application scenario of a MRI device according to some embodiments of the present disclosure.

As shown in FIG. 1A, an application scenario 100 may include an electronic device 110, a MRI device 120, a processor 130, a storage device 140, and a network 150.

The electronic device 110 refers to any device composed of electronic components. In some embodiments, the electronic device 110 may include a first electronic device associated with magnetic resonance scanning. For example, the electronic device 110 may include a wireless coil, a scanning bed, a power transmitting module, a signal receiving module, and a safety monitoring module. In some embodiments, the electronic device 110 may further include a second electronic device unrelated to magnetic resonance scanning. For example, the electronic device 110 may include a monitoring module of a subject, a sensing module of the subject, a hyperbaric injection module, a physiological monitoring module, a subject care module, an environmental monitoring module, a mobile controller carried by a caregiver and/or a physician, a computer carried by the caregiver and/or the physician, or a cell phone carried by the caregiver and/or the physician. The subject refers to an object undergoing scanning and serving as the target for image data acquisition. For example, the subject includes a patient, an animal model used for technical validation (e.g., mice, rats, etc.), an anthropomorphic phantom employed for system calibration (e.g., head phantoms or abdominal organ-specific phantoms), a healthy volunteers participating in imaging protocol optimization studies, a biological tissue specimen used in comparative experiments (e.g., excised liver tissue or bone samples), etc.

In some embodiments, electronic devices, such as cell phones and computers, include a dedicated channel for frequency adjustment to ensure that the operating frequencies of the electronic devices fall outside the operating frequency of the MRI device. For example, the dedicated channel enables clock synchronization between the electronic devices and the MRI device.

In some embodiments, the frequency adjustment for the electronic devices may also be implemented via an external channel, such as an external module connected to the electronic devices through a predefined interface.

In some embodiments, the operating frequency of the electronic device 110 may fall within the operating frequency of the MRI device 120 (e.g., the operating frequencies of the electronic device 110 and the MRI device 120 may at least partially overlap), which may cause interference to the operation of the MRI device 120. The MRI device 120 may adjust the operating frequency of the electronic device located inside the scanning room or entering the scanning room, such that the operating frequency of the electronic device is outside the operating frequency of the MRI device.

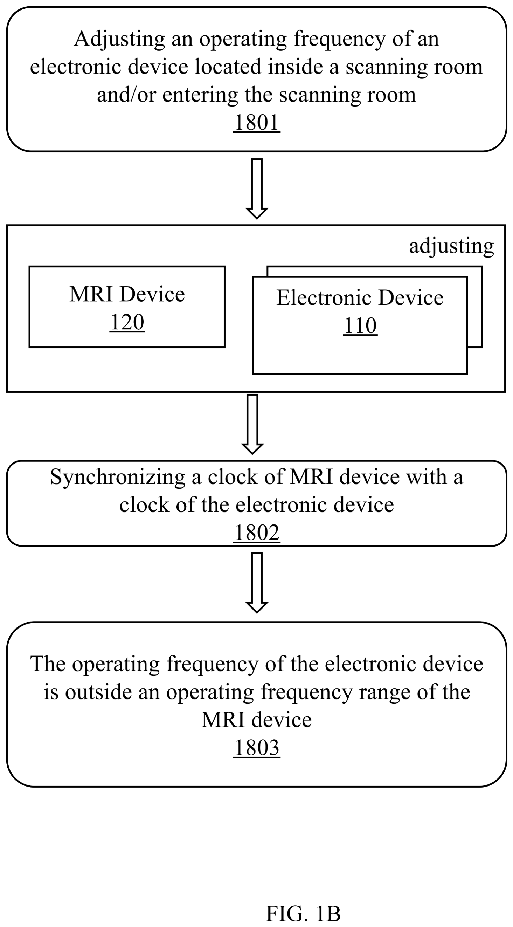

More descriptions regarding the electronic device 110 and the adjustment of the operating frequency of the electronic device 110 may be found in relevant parts of the present disclosure below (e.g., FIGs. 1B-10).

The MRI device 120 is configured to collect imaging data related to an object. The imaging data related to the object may include images (e.g., image slices), projection data, or a combination thereof. In some embodiments, the MRI device 120 is located inside a scanning room 170. The scanning room refers to a space where the MRI device 120 is located. The scanning room may enable the MRI device to be shielded from the outside, so as to ensure the accuracy of MRI results.

In some embodiments, the MRI device 120 is also referred to as an MR device or an MR scanner. In some embodiments, the MRI device 120 may include a multi-modal imaging device, such as a PET-MRI device.

In some embodiments, the MRI device 120 may adjust the operating frequency of at least one electronic device located inside the scanning room 170 or an electronic device that is entering the scanning room 170, such that the operating frequency of the electronic device is outside the operating frequency of the MRI device. For example, the electronic device 110 may represent an electronic device that will enter the scanning room, and an electronic device 110-1 may represent an electronic device that has entered the scanning room.

In some embodiments, the application scenario 100 of the MRI device may further include an anti-interference device 160. In some embodiments, the anti-interference device 160 is configured to adjust the operating frequency of the electronic device located inside the scanning room and/or entering the scanning room. The adjusted frequency of the electronic device is outside the operating frequency of the MRI device. In some embodiments, the anti-interference device 160 is configured to synchronize a clock of the electronic device located inside the scanning room and/or entering the scanning room with a clock of the MRI device.

In some embodiments, the anti-interference device 160 is removably mounted on the electronic device 110-1.

In some embodiments, the anti-interference device 160 is removably mounted on the MRI device 120.

The processor 130 may process data and/or information. For example, the MRI device 120 may adjust the operating frequency of the electronic device 110 located inside the scanning room or entering the scanning room via the processor 130, such that the operating frequency of the electronic device is outside the operating frequency of the MRI device.

In some embodiments, the processor 130 may be a single server or a server group. The server group may be centralized or distributed. In some embodiments, the processor 130 may be local or remote. For example, the processor 130 may access information and/or data from the electronic device 110 and/or the MRI device 120 via the network 150. In some embodiments, the processor 130 may be implemented on a cloud platform. For example, the cloud platform may include a private cloud, a public cloud, a hybrid cloud, a community cloud, a distributed cloud, an inter-cloud, a multi-cloud, or the like, or any combination thereof. In some embodiments, the processor 130 may be part of the MRI device 120.

The storage device 140 may store data, instructions, and/or any other information. In some embodiments, the storage device 140 may store data obtained from the electronic device 110, the MRI device 120, and/or the processor 130. The data may include the operating frequency of the electronic device 110, the operating frequency of the MRI device 120, or the like.

In some embodiments, the storage device 140 may store data and/or instructions that the MRI device 120 and/or the processor 130 may execute or use to execute the exemplary processes described in the present disclosure. In some embodiments, the storage device 140 may include a mass storage, a removable storage, a volatile read-write memory, a read-only memory (ROM), or any combination thereof. In some embodiments, the storage device 140 may be implemented on a cloud platform. Merely by way of example, the cloud platform may include a private cloud, a public cloud, a hybrid cloud, a community cloud, a distributed cloud, an inter-cloud, a multi-cloud, or the like, or any combination thereof.

The network 150 may include any suitable network that may facilitate the exchange of information and/or data in the application scenario 100. In some embodiments, at least one component of the application scenario 100 (e.g., the electronic device 110, the MRI device 120, the processor 130, the storage device 140, etc.) may transmit information and/or data to at least one other component of the application scenario 100 via the network 150. For example, the processor 130 may transmit wireless clock signals to the electronic device 110 via wireless clock broadcasting based on the network 150. In some embodiments, the network 150 may include at least one network access point. For example, the network 150 may include wired and/or wireless network access points (e.g., base stations and/or Internet exchange points) via which at least one component of the application scenario 100 may connect to the network 150 to exchange data and/or information.

The description of the present disclosure is intended to be illustrative, rather than limiting the scope of the present disclosure. Many alternatives, modifications, and variations will be apparent to those skilled in the field. Features, structures, methods, and other characteristics of the exemplary embodiments described in the present disclosure may be combined in various ways to obtain additional and/or alternative exemplary embodiments. However, these variations and modifications do not depart from the scope of the present disclosure. In some embodiments, the application scenario 100 may include at least one additional component and/or at least one of the aforementioned components may be omitted. Additionally or alternatively, at least two components of the application scenario 100 of the MRI device may be integrated into a single component. Components of the application scenario 100 may be implemented on at least two sub-components.

FIG. 1B is a schematic diagram illustrating of an exemplary magnetic resonance imaging (MRI) method according to some embodiments of the present disclosure. In some embodiments, the MRI method provided by some embodiments of the present disclosure may be executed by the MRI device 120 (e.g., the processor 130).

In some embodiments, as shown in FIG. 1B, in 1801, the MRI device 120 (or the processor 130) adjusting the operating frequency of the electronic device 110 located inside the scanning room 170 and/or entering the scanning room 170. In 1803, the operating frequency of the electronic device 110 is adjusted to be outside the operating frequency of the MRI device 120. For example, before the MRI device 120 collects imaging data, the MRI device 120 (or the processor 130) adjusts the operating frequency of each electronic device 110 inside the scanning room 170, such that the operating frequency of the electronic device 110 is outside the operating frequency of the MRI device 120. As another example, when any electronic device 110 enters the scanning room, the MRI device 120 (or the processor 130) adjusts the operating frequency of the electronic device 110, such that the operating frequency of the electronic device 110 is outside the operating frequency of the MRI device 120. In some embodiments, the adjustment of the operating frequency is performed by 1802. In 1802, a clock of the MRI device 120 is synchronized with a clock of the electronic device 110.

The operating frequency of the MRI device refers to a frequency range in which collected signals of the MRI devices are distributed when signals are collected by modulating gradient magnetic fields and RF signals during imaging using MRI technology. In some embodiments, the operating frequency of the MRI device is related to nuclides and magnetic field strengths. For example, for hydrogen nuclei: when the magnetic field strength is 3T, the RF signals with a central frequency of 128 MHz and a certain bandwidth (e.g., ±0.3 MHz) are collected. That is, the operating frequency of the MRI device is 128 ± 0.3 MHz. When the magnetic field strength is 5T, the RF signals with the central frequency of 200 MHz and the certain bandwidth are collected. That is, the operating frequency of the MRI device is 200 ± 0.3 MHz. When the magnetic field strength is 1.5T, the RF signals with the central frequency of 64 MHz and the certain bandwidth are collected. That is, the operating frequency of the MRI device is 64 ± 0.3 MHz. As another example, for sodium nuclei: when the magnetic field strength is 3T, the RF signals with the central frequency of 30 MHz and the certain bandwidth are collected. That is, the operating frequency of the MRI device is 30 ± 0.3 MHz. When the magnetic field strength is 1.5T, the RF signals with the central frequency of 15 MHz and the certain bandwidth are collected. That is, the operating frequency of the MRI device is 15 ± 0.3 MHz.

In some embodiments, the electronic device 110 may include a first electronic device associated with a magnetic resonance scanning process.

The first electronic device refers to a device that is involved in the MRI process and directly participates in or supports the magnetic resonance scanning process. In some embodiments, the first electronic device may include at least one of a wireless coil, a scanning bed, a power transmitting module, a signal receiving module, a safety monitoring module, or the like.

The wireless coil is also referred to as a RF coil or an RF coil. The wireless coil includes a set of conductors (usually copper wires) arranged in a specific geometric shape to form a device capable of generating and receiving RF magnetic fields. The wireless coil is configured to receive RF (RF) signals, which are configured to detect nuclear magnetic resonance phenomena in tissues. The wireless coil may include a body coil, a surface coil, a phased array coil, or the like.

In some embodiments, the wireless coil may include a coil and a magnetic resonance signal receiver. The coil is configured to receive RF signals. The magnetic resonance signal receiver is configured to convert the RF signals into digital signals and transmit the digital signals in a wireless manner.

The RF signals refer to signals configured to excite and detect magnetic resonance phenomena in tissues inside a subject.

The scanning bed refers to a bed in the MRI device that is configured to place a subject for scanning. In some embodiments, the scanning bed is provided with an electronic controller to control movement of the scanning bed during the magnetic resonance scanning process.

The power transmitting module refers to a module configured to adjust and transmit power of the RF signals. The power transmitting module is configured to manage and control transmission and reflection of the RF signals. By reflecting unnecessary RF signals, the power transmitting module prevents electromagnetic interference, improves signal-to-noise ratio, protects electronic devices, optimizes RF field distribution, and thereby enhances overall performance of the MRI system and image quality.

In some embodiments, the MRI device controls an output power via the power transmitting module to provide RF pulses.

The signal receiving module refers to a module configured to receive RF signals emitted by excited hydrogen nuclei inside the subject. The signal receiving module is configured to receive the RF signals emitted by excited hydrogen nuclei in the subject.

In some embodiments, the MRI device may receive, amplify, preprocess, digitize, and transmit RF signals via the signal receiving module to ensure the generation of high-quality images

The safety monitoring module refers to a module configured to monitor and manage relevant parameters (e.g., a magnetic field strength, a RF radiation level, or the like) during the magnetic resonance scanning process in real time. In some embodiments, the safety monitoring module includes a sensor, an alarm, or other safety equipment. By monitoring and managing a plurality of safety parameters in real time, the safety monitoring module may prevent and address potential hazardous situations, enhance the overall safety and reliability of the MRI system, and ensure the safety of the subject or an operator.

In some embodiments, the MRI device may monitor and manage relevant parameters in real time via the safety monitoring module, thereby preventing and addressing potential hazardous situations in advance, enhancing the overall safety and reliability of the MRI device, and ensuring the safety of the subjects or the operators.

In some embodiments, the electronic device 110 includes a second electronic device unrelated to magnetic resonance scanning.

The second electronic device refers to a device that does not directly participate in or support the magnetic resonance scanning process. In some embodiments, the second electronic device may include at least one of a monitoring module for a subject, a sensing module for the subject, a hyperbaric injection module, a physiological monitoring module, a subject care module, an environmental monitoring module, a mobile controller carried by a caregiver and/or a physician, a computer carried by the caregiver and/or the physician, a cell phone carried by the caregiver and/or the physician, or the like.

The monitoring module for a subject refers to a module configured to monitor vital signs of the subject in real time and provide early warnings. For example, the monitoring module may include a respiration monitor, an alarm, or the like. In some embodiments, the MRI device may monitor physiological parameters and conditions of the subject in real time via the monitoring module, which helps the operators detect and address potential emergencies on time and ensures the smooth progress of the magnetic resonance scanning process.

The sensing module for the subject refers to a module configured to sense a plurality of physiological conditions of the subject in real time during the magnetic resonance scanning process. For example, the sensing module for the subject includes may include a pressure pad, etc.

In some embodiments, the MRI device may sense the physiological conditions of the subject in real time via the sensing module for the subject (e.g., pressure distribution, or the like), and may detect abnormal situations (e.g., subject movement or discomfort) in a timely manner during the magnetic resonance scanning process, thereby taking measures to prevent potential risks.

The hyperbaric injection module refers to a module configured to inject a contrast agent or the like into the subject during a contrast-enhanced scanning. For example, the hyperbaric injection module includes a syringe, an injection pump, or the like. The MRI device may inject the contrast agent quickly and accurately via the hyperbaric injection module, which may not only significantly improve image quality and diagnostic accuracy, but also ensure safety of the subject.

The physiological monitoring module refers to a module configured to monitor the physiological data of the subject. Physiological monitoring may include a plurality of types of monitoring, including heart rate monitoring, respiration monitoring, blood oxygen saturation monitoring, blood pressure monitoring, body temperature monitoring, or the like. In some embodiments, the physiological monitoring module includes a heart rate monitor, a respiration monitor, a blood oxygen saturation monitor, a sphygmomanometer, a body temperature monitor, or the like. The MRI device may monitor the physiological parameters of the subject in real time during the magnetic resonance scanning process via the physiological monitoring module, thereby ensuring continuous monitoring of vital signs of the subject, and helping the operator detect and address abnormal situations on time.

The subject care module refers to a module configured to assist the subject in undergoing a MRI examination and provide a comfortable environment. For example, the subject care module includes a temperature control device, a lighting adjustment device, or the like. The MRI device may provide physiological monitoring, psychological support, physical support, and handling of corresponding emergency situations for the subject via the subject care module. The subject care module helps the operators detect and address potential emergency situations on time, and ensure smooth progress of the magnetic resonance scanning process.

The environmental monitoring module refers to a module configured to monitor and manage one or more environmental parameters in the scanning room in real time. For example, the environmental monitoring module includes a temperature sensor, a humidity sensor, a magnetometer, or the like. The MRI device may monitor and manage the environmental parameters in the scanning room in real time via the environmental monitoring module. The environmental monitoring module helps the operators detect and address potential environmental issues on time, and ensure smooth progress of the magnetic resonance scanning process.

The mobile controller refers to a device configured to remotely control the MRI device or interact with the subject. For example, the mobile controller includes a handheld terminal, walkie-talkies, or the like.

In some embodiments, the MRI device may improve scanning efficiency and subject safety via the mobile controller, while optimizing work processes, reducing misoperations, enhancing aseptic operation capabilities, and allowing the operators to perform multitasking.

In some embodiments of the present disclosure, via use of the second electronic device unrelated to magnetic resonance scanning, vital signs and physiological indicators of the subject or the like may be well monitored, safety of the subject may be ensured, and comfort of the subject may be improved.

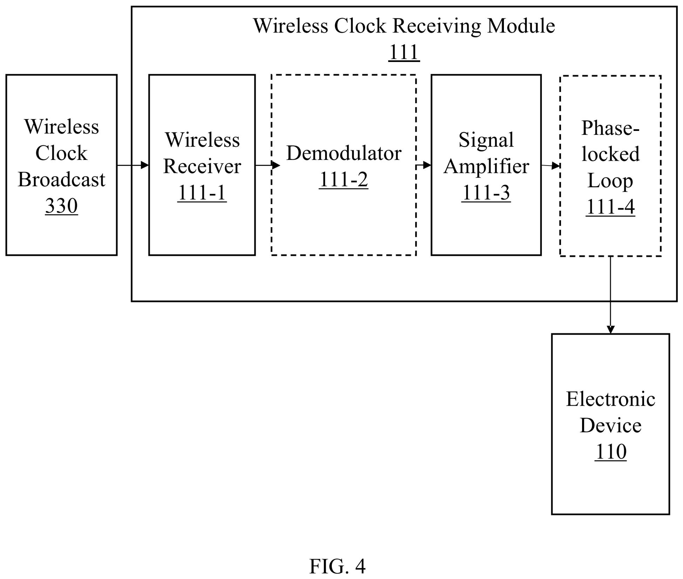

In some embodiments, the electronic device 110 includes a wireless clock receiving module. The wireless clock receiving module includes a wireless receiver and a signal amplifier. In some embodiments, the wireless receiver is configured to receive the wireless clock signals and perform signal conversion. The signal amplifier is configured to amplify converted signals. For more descriptions regarding the wireless clock receiving module, may be found in the related descriptions in FIG. 4.

The operating frequency of the electronic device 110 refers to a frequency at which the electronic device 110 transmits or receives an electromagnetic wave in an operating state. The operating frequency of the electronic device may be a fixed value, or may be a frequency range, etc. The operating frequencies of the different electronic devices are different from each other.

In some embodiments, the MRI device 120 (or the processor 130) may adjust the operating frequency of the electronic device 110 located inside the scanning room and/or entering into the scanning room in a plurality of manners. The operating frequency of the electronic device 110 is outside the operating frequency of the MRI device. Interference of the electronic device 110 on the MRI device 120 is avoided.

In some embodiments, the MRI device 120 (or the processor 130) may adjust the operating frequency of the electronic device located inside the scanning room. For example, the MRI device 120 may adjust the operating frequency of the first electronic device located inside the scanning room.

In some embodiments, the MRI device 120 may adjust the operating frequency of the electronic device 110 entering the scanning room. For example, the MRI device 120 may adjust the operating frequency of the second electronic device entering the scanning room (e.g., the monitoring module for the subject, the sensing module for the subject, or the like that enter into the scanning room during the magnetic resonance scanning).

In some embodiments, the MRI device 120 may adjust the operating frequency of the electronic device 110 located inside the scanning room 170 and the operating frequency of the electronic device 110 that is entering the scanning room 170 at the same time.

In some embodiments, adjusting the operating frequency of the electronic device 110 located inside the scanning room and/or entering into the scanning room, so that the operating frequency of the electronic device 110 is outside the operating frequency of the MRI device 120, may be implemented via synchronizing a clock of the electronic device 110 with a clock of the MRI device 120.

The clock refers to a timer configured to synchronize and coordinate one or more hardware operations inside an electronic device. Each electronic device has its own clock signals, which may be understood as stable periodic pulse signals generated inside the electronic device. Such clock signals, similar to a "heartbeat", provide a basic time reference for the electronic device. For example, inside the electronic device, there is a crystal oscillator. The clock signals generated by the crystal oscillator provide synchronization signals for a plurality of components, ensuring the electronic device performs operations such as transmitting and receiving electromagnetic waves and processing data in accordance with the same time rhythm. Such clock signals, similar to a "heartbeat", serve as reference signals.

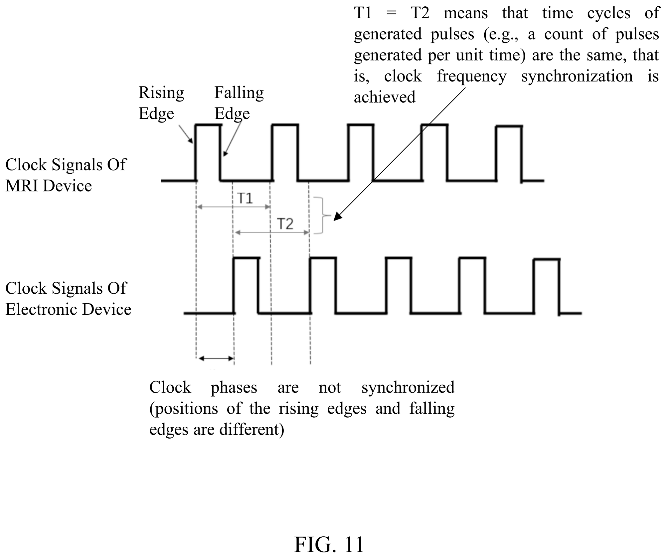

The clock signal includes a clock frequency and a clock phase. The clock frequency refers to a count of pulses generated per second. The clock phase refers to positions of rising edges and falling edges of pulses of the clock signal. For example of the rising edges and the falling edges, refer to the example in FIG. 11. FIG. 11 is a schematic diagram illustrating of the exemplary clock signal according to some embodiments of the present disclosure.

Clock synchronization refers to synchronizing a clock of the MRI device 120 with a clock of the at least one electronic device 110 under a common-source clock. In a standard operating procedure of the MRI device 120, the MRI device 120 needs to achieve common-source clock synchronization inside the scanning room 170. For example, all electronic devices 110 need to share the same master clock signal source (a standard clock source). Via precise frequency planning, the operating frequency of the electronic device 110 is adjusted to be outside the operating frequency of the MRI device 120, which may effectively suppress noise within the frequency bandwidth of the MRI device 120.

In some embodiments of the present disclosure, the clock synchronization may refer to synchronizing clock frequencies without synchronizing clock phases. For example, the clock frequency of the electronic device 110 is adjusted to be the same as the clock frequency of the MRI device 120 (i.e., T1 = T2 in FIG. 11), while the clock phases (e.g., the rising edges and the falling edges of clock pulse signals) do not need to be completely the same. For example, a fixed delay may exist in time. Synchronizing both clock frequencies and clock phases means that not only pulse cycles are the same, but also phases are the same. For example, the rising edges and the falling edges of pulses need to be completely aligned.

In some embodiments, the clock frequency of the clock signals of the electronic device 110 is adjusted to be synchronized with the clock frequency of the MRI device 120. For example, if the clock frequency of the MRI device 120 is 10 MHz, the clock frequency of the electronic device 110 is also synchronized to 10 MHz via the clock synchronization. Via a phase-locked loop (PLL), the synchronized clock frequency of the electronic device 110 is converted into a target frequency unrelated to the operating frequency band of the MRI device 120. For example, the clock frequency of the electronic device 110 is converted into the target frequency to be adjusted to via the phase-locked loop. In some embodiments, via feedback control of the phase-locked loop, the clock frequency of the electronic device 110 is multiplied by a frequency multiplication factor to obtain the target frequency.

For example, if the clock frequency of the MRI device 120 is 10 MHz, and the frequency multiplication factor of the phase-locked loop of the MRI device 120 is 12.8, the operating frequency of the MRI device 120 is 128 MHz (the RF signals within a certain bandwidth (±0.3 MHz) with a center frequency of 128 MHz are acquired). The clock frequency of the electronic device 110 is also 10 MHz. To make the operating frequency of the electronic device 110 outside the 128 MHz operating frequency of the MRI device 120 and avoid affecting the operation of the MRI device 120, the frequency multiplication factor of the phase-locked loop of the electronic device 110 may be set to a value not equal to 12.8 (e.g., 6). In this case, the operating frequency of the electronic device 110 is 60 MHz. The operating frequency of the electronic device 110 is outside the operating frequency of the MRI device 120, thereby enabling the use of the electronic device 110 inside the scanning room.

In some embodiments, synchronizing the clock of the MRI device 120 with the clock of the electronic device 110 includes synchronizing the clock of the MRI device 120 with a clock of the first electronic device.

In some embodiments of the present disclosure, the operating frequency of the electronic device 110 and the operating frequency of the MRI device 120 may at least partially overlap, thereby causing interference. Therefore, via synchronizing the clock of the first electronic device associated with the magnetic resonance scanning with the clock of the MRI device 120, frequency interference between the MRI device 120 and the first electronic device during the magnetic resonance scanning process may be avoided, image quality and signal-to-noise ratio (SNR) may be improved, and accuracy of diagnostic results may be enhanced.

In some embodiments, synchronizing the clock of the MRI device 120 with the clock of the electronic device 110 includes synchronizing the clock of the MRI device 120 with a clock of the second electronic device.

In some embodiments of the present disclosure, via synchronizing the clock of the second electronic device with the clock of the MRI device 120, frequency interference between the MRI device 120 and the second electronic device during the magnetic resonance scanning process may be avoided. This may not only improve the image quality and the signal-to-noise ratio (SNR) and enhance the accuracy of diagnostic results, but also assist processes such as monitoring, sensing, and care of the subject or the environment during the magnetic resonance scanning process.

In some embodiments, a manner of synchronizing the clock of the MRI device 120 with the clock of the electronic device 110 includes at least one of the following manners: connecting the MRI device 120 and the electronic device 110 via a cable; or transmitting the wireless clock signals to the electronic device 110 via wireless clock broadcasting, or the like.

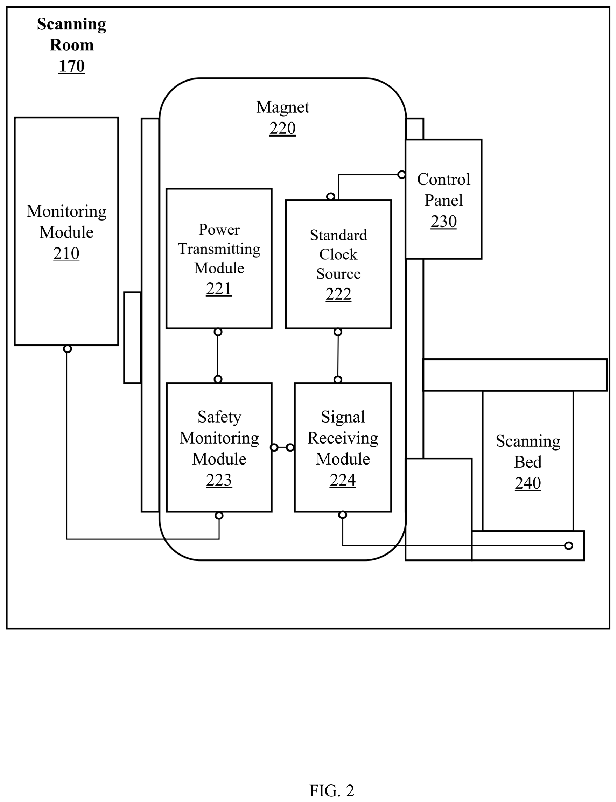

In some embodiments, the MRI device 120 and the electronic device 110 may be connected via the cable and perform the clock synchronization. For example, the MRI device 120 may transmit clock signals to each electronic device inside the scanning room 170 via the cable, thereby achieving clock synchronization between the electronic device 110 and the MRI device 120. More descriptions regarding the relevant content may be found in the related descriptions of FIG. 2.

In the present embodiment, a cable is arranged between the MRI device 120 and the electronic device 110, and wired clock signals are transmitted via the cable to achieve the clock synchronization.

In the present embodiment, by converting the wired clock signals into the wireless clock signals and broadcasting the wireless clock signals in the scanning room 170, when the electronic device 110 enters the scanning room 170, the electronic device 110 may automatically receive the wireless clock signals broadcast in the scanning room 170 via a standard wireless clock receiving module, thereby achieving the effect of synchronizing with the standard clock signals. The wireless clock broadcasting is simple and easy to implement, which may remove heavy RF cables, simplify the connection interfaces of movable components, and save costs. The wireless clock broadcasting can also realize automatic clock synchronization of mobile products inside the scanning room, support intelligent electronic devices to enter the scanning room, and avoid complex testing and screening of the electronic devices.

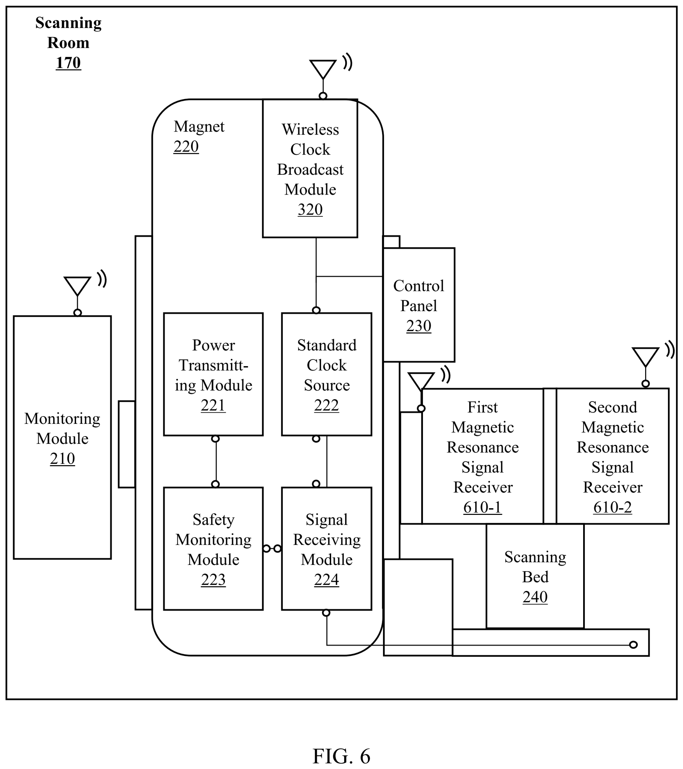

The standard clock signals refer to reference clock signals generated by the standard clock source and characterized by a stable frequency. The wireless clock signals refer to wireless signals transmitted by a wireless clock broadcast module and propagated within the scanning room. The wireless clock signals are generated based on the standard clock signal as the original signal. The standard clock signal is amplified by a power amplifier and then converted into wireless clock signals by a wireless transmitter (optionally via a modulator). The wireless clock broadcasting refers to transmitting signals to the electronic device 110 via a wireless broadcasting manner (e.g., the manner in which the MRI device 120 performs wireless broadcasting). The wireless clock broadcasting propagates in the space of the magnetic resonance scanning room through a carrier. The carrier including at least one of infrared light, electromagnetic waves, or ultrasonic waves. More information regarding the relevant content may be found in the related descriptions of FIGs. 6 to 8. In some embodiments, the electromagnetic waves are 5.8GHz carrier waves. In some embodiments, the infrared light is generated by a laser generator.

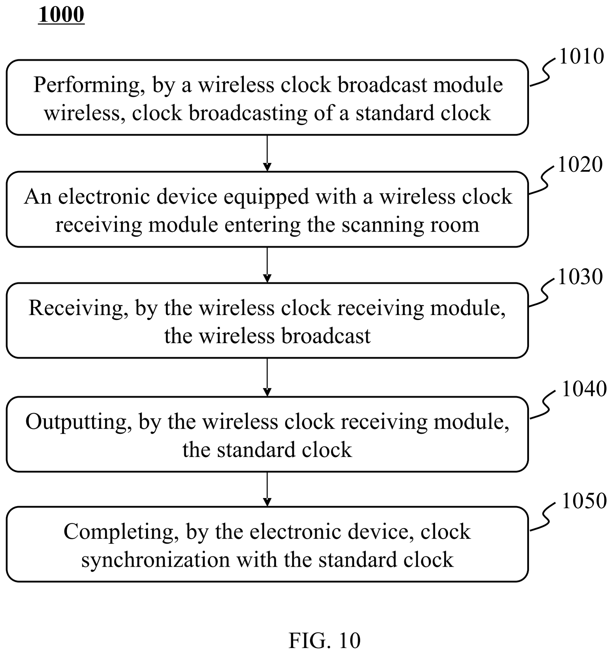

In some embodiments, in the form of the wireless clock broadcasting, the electronic device 110 may synchronize its internal clock with the standard clock source via the wireless clock synchronization after receiving the wireless clock signals, thereby ensuring the clock synchronization between the MRI device 120 and the electronic device 110. For more descriptions regarding the wireless clock synchronization, may be found in the relevant description in FIG. 10.

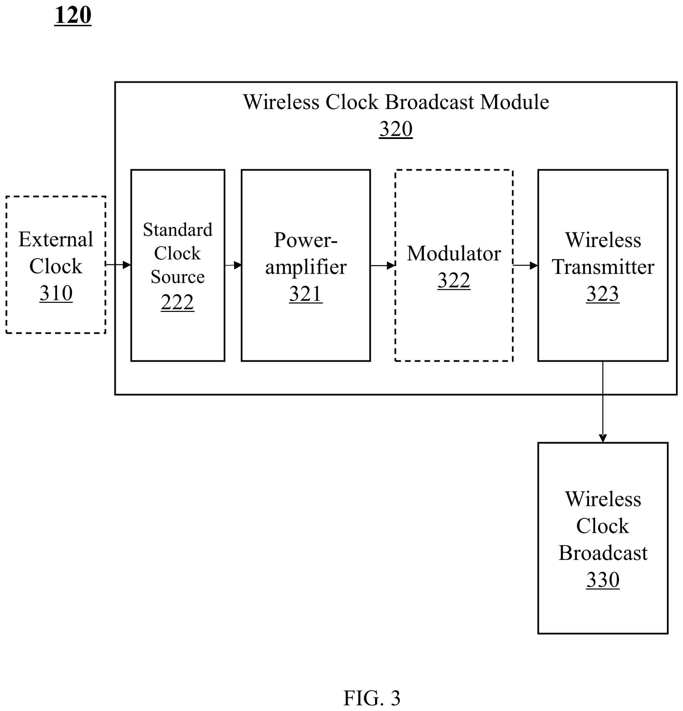

In some embodiments, the MRI device 120 includes a wireless clock broadcast module. The wireless clock broadcast module is configured to transmit the wireless clock signals to the electronic device 110 via the wireless clock broadcasting. More descriptions may be found in the relevant description in FIG. 3. In some embodiments, the wireless clock broadcast module may be installed inside the scanning room 170 to transmit the wireless clock signals to the electronic device 110. The wireless clock broadcasting module is installed in the scanning room, for example, as a part of the MRI device.

In some embodiments, when there is a plurality of electronic devices 110, transmitting the wireless clock signals to the electronic devices 110 via the wireless clock broadcasting includes: transmitting the wireless clock signals to each of the plurality of electronic devices 110 separately and unidirectionally in a one-to-many manner via the wireless clock broadcasting.

In some embodiments, the MRI device 120 includes one wireless clock broadcast module. One electronic device 110 corresponds to one signal receiving module. A plurality of electronic devices 110 correspond to a plurality of signal receiving modules. The one-to-many manner refers to that the wireless clock signals transmitted by the one wireless clock broadcast module may be received by the plurality of signal receiving modules corresponding to the plurality of electronic devices 110.

The term "unidirectionally" refers to that the wireless clock broadcast module transmits the wireless clock signals to the plurality of signal receiving modules, and the plurality of signal receiving modules do not need to feed back information (e.g., feedback of the clock frequency or the clock phase, etc.) to the wireless clock broadcast module.

In some embodiments of the present disclosure, via the one-to-many manner, each electronic device 110 entering the scanning room 170 or each electronic device 110 inside the scanning room may obtain the wireless clock signals from the wireless clock broadcasting, thereby completing the clock synchronization. By sending the wireless clock signal to the electronic device 110 unidirectionally, the implementation cost may be greatly reduced, and the volume and power consumption of the wireless clock broadcast module in the MRI device and the signal receiving module in the electronic device may be reduced.

The wireless clock receiving module does not need to return phase information to the wireless clock broadcast module, which may avoid complex algorithms and adjustments. Therefore, no computing device for running algorithms is required, which greatly reduces the implementation cost and minimizes the volume and power consumption of the wireless clock broadcast module and the wireless clock receiving module.

In some embodiments, the MRI device 120 may implement clock synchronization via any single manner of the following: connecting the MRI device 120 and the electronic device 110 via a cable; or transmitting the wireless clock signals to the electronic device 110 via the wireless clock broadcasting, or the like. In some embodiments, the clock synchronization may also be implemented via a combination of any two or all three of the aforementioned manners. For example, for some electronic devices 110 that are close to the MRI device 120 (e.g., a distance between the MRI device 120 and the electronic device 110 is less than a threshold), the MRI device 120 and the electronic device 110 may be connected via a cable. As another example, for some electronic devices 110 that are close to the MRI device 120 (e.g., the distance between the MRI device 120 and the electronic device 110 is less than the threshold), the MRI device 120 and the electronic device 110 may be connected via a cable; for some other electronic devices 110 that are far from the MRI device 120 (e.g., the distance between the MRI device 120 and the electronic device 110 is not less than the threshold), the wireless clock signals may be transmitted to the electronic device 110 via the wireless clock broadcasting for the clock synchronization.

In some embodiments, the wireless clock signals are configured to synchronize a first clock frequency of the electronic device 110 with a second clock frequency of the MRI device 120.

The first clock frequency refers to an adjusted clock frequency of the electronic device 110. The clock frequency refers to a count of pulses generated per second.

The second clock frequency is a clock frequency of the MRI device 120. A value of the second clock frequency may be preset.

In some embodiments, the synchronization of the clock frequencies of the electronic device 110 and the MRI device 120 refers to that the frequencies of the two clocks of these two devices are the same, but the phases are not necessarily the same. That is, clock cycles of the two devices are the same, but a fixed delay may exist in time.

In some embodiments, the wireless clock signals are not configured to synchronize a first clock phase of the electronic device 110 with a second clock phase of the MRI device 120 (e.g., avoid synchronizing the first clock phase and the second clock phase).

The first clock phase refers to a clock phase of the electronic device 110. The clock phase refers to positions of a rising edge and a falling edge of a clock signal. The second clock phase refers to a clock phase of the MRI device 120.

In some embodiments, a phase synchronization of the electronic device 110 and the MRI device 120 refers to that the two clocks of these two devices have a same frequency and a same phase. That is, the rising edges and the falling edges of the two clock signals of these two devices are completely consistent without any time difference.

In some embodiments, during the clock synchronization, only the first clock frequency of the electronic device 110 and the second clock frequency of the MRI device 120 are synchronized via the wireless clock signals, so that the adjusted frequency of the electronic device 110 is outside the operating frequency of the MRI device 120. The wireless clock signals do not include relevant information about phases, and thus there is no need to perform synchronization processing on the first clock phase of the electronic device 110 and the second clock phase of the MRI device 120.

In some embodiments of the present disclosure, by only synchronizing frequencies without synchronizing phases, the need for the MRI device 120 and the electronic device 110 to use complex algorithms to adjust the phase of the electronic device may be avoided. Therefore, no computing device for running algorithms is required, which greatly reduces the implementation cost and minimizes the volume and power consumption of the MRI device 120 and the electronic device 110. For example, the volume and power consumption of the wireless clock broadcast module in the MRI device 120 and the signal receiving module in the electronic device 110 may be reduced. More descriptions regarding the wireless clock broadcast module may be found in the related descriptions of FIG. 3. More descriptions regarding the signal receiving module may be found in the related descriptions of FIG. 4.

In some embodiments, the MRI device 120 (or the processor 130) may adjust the operating frequency of the electronic device 110 in a plurality of ways. In some embodiments, the MRI device 120 may use a communication protocol (e.g., Bluetooth LE, Zigbee, or the like) to adjust the operating frequency of the electronic device 110 to be outside the operating frequency of the MRI device 120.

In some embodiments, the MRI device 120 (or the processor 130) may also use algorithms (e.g., a machine learning algorithm, a dynamic adjustment algorithm, or the like) to coordinate operation cycles of the MRI device 120 and the electronic device 110, so as to avoid signal overlap. For example, the processor 130 may obtain relevant signals of the MRI device 120 (e.g., audio noise, an environmental magnetic field change, a power line fluctuation, or the like) and relevant signals of the electronic device 110, and coordinate the operation cycles of the MRI device 120 and the electronic device 110 by using manners such as the machine learning algorithm or the dynamic adjustment algorithm. For example, key operations of the electronic device 110 may be performed in intervals between time points for emitting RF pulses by the MRI device 120 to reduce the superposition effect of electromagnetic interference (EMI).

In some embodiments, the MRI device 120 (or the processor 130) may also analyze electromagnetic radiation characteristics of the electronic device 110 (e.g., a radiation intensity, a frequency range, or the like), establish an interference model to predict the impact of the electronic device 110 on the MRI device 120. The interference model is optimized via real-time monitored data, and precise regulation strategies are generated based on the interference model. The interference model may be a machine learning model, such as one or more of a regression model (e.g., Random Forest, GBRT), a classification model (e.g., SVM, or CNN, etc.), LSTM, a Transformer, a graph neural network (e.g., GNN), or the like.

In some embodiments, an input of the interference model includes electromagnetic radiation characteristics of the electronic device 110, a state of the electronic device 110, and a system state of the MRI device 120, and an output includes a score of MRI quality. The electromagnetic radiation characteristics of the electronic device 110 include spectral characteristics of the electronic device 110 (e.g., a power at a specific frequency point, a peak frequency and an amplitude, an occupied bandwidth, or the like) and time-domain characteristics of the electronic device 110 (e.g., a rise/fall time (the rising edge/the falling edge) of pulse signals, a duty cycle, a repetition frequency, a mean value, a variance, a peak value of signal amplitude, or the like). The state of the electronic device 110 includes a working mode of the electronic device 110 (e.g., standby, Bluetooth transmission, motor drive, high-power sampling, or the like), supply voltage/current, device ID, or the like. The system state of the MRI device 120 includes a type of current scanning sequence (e.g., a gradient echo sequence, a spin echo sequence, an echo planar imaging, etc.), key sequence parameters (e.g., a repetition time, an echo time, a flip angle, a receiving bandwidth, etc.), a transmission frequency range, a receiving frequency range, or the like. The score of MRI quality is a quantitative evaluation index for the image quality obtained by the scanning of the MRI device 120. The image quality obtained by the scanning of the MRI device 120 may be evaluated by scores or levels (e.g., low, medium, high, etc.).

In some embodiments, the interference model may be obtained through training. Training samples of the interference model include sample electromagnetic radiation characteristics, sample states of electronic devices, and sample system states of MRI devices. Training labels include scores of sample MRI quality. The training samples and the training labels of the interference model may be obtained through historical MRI scanning processes. For example, the training samples may be constructed based on data in historical MRI scanning processes. The training labels may be obtained by manual annotation.

In some embodiments, the MRI device 120 (or the processor 130) may dynamically adjust operating parameters of the electronic device 110 according to the score of MRI quality. For example, when the score of MRI quality is low (lower than a preset threshold quality score), the electronic device 110 may be switched to ultra-low power standby, or only perform the basic functions, or the allowed operating frequency bands/power upper limits of the electronic device 110 may be set. Dynamic adjustment refers to continuously obtaining (or obtaining at preset time intervals, e.g., every 5 seconds) the electromagnetic radiation characteristics of the electronic device 110, the state of the electronic device 110, and the system state of the MRI device 120 to predict the score of MRI quality. The operating parameters of the electronic device 110 are adjusted according to the predicted score of MRI quality.

In some embodiments, the MRI device 120 (or the processor 130) may also transmit carrier signals with fixed frequencies via wireless links (e.g., Bluetooth, Zigbee, or the like). The electronic device 110 detects the frequency deviation of the carrier signals and adjusts the local clock of the electronic device 110, thereby only synchronizing the frequency without synchronizing the phase.

In some embodiments, the MRI device 120 may also use a high-precision frequency source such as a rubidium atomic clock, and distribute frequency signals of the high-precision frequency source via wireless links (e.g., optical fiber or millimeter waves). The electronic device 110 locks to the frequency signals to achieve frequency synchronization between the local clock of electronic device 110 and the atomic clock.

In some embodiments, the MRI device 120 may also synchronize both the frequency and the phase during wireless clock synchronization to solve the complexity problem caused by phase synchronization. For example, the MRI device 120 may establish a synchronization model in the scanning room 170.

The synchronization model is a machine learning model. The synchronization model may synchronize both the frequencies and the phases of clocks of the electronic device 110 entering the scanning room 170 or already inside the scanning room 170 with the MRI device 120.

An input of the synchronization model includes the frequencies and the phases of the clocks of the electronic device 110 and the MRI device 120 before synchronization. An output of the synchronization model includes the frequencies and the phases of the clocks of the electronic device 110 and the MRI device 120 after synchronization. Training data of the synchronization model may include the frequencies and the phases of the clocks of the electronic device 110 and the MRI device 120 before synchronization in historical data. Training labels of the synchronization model include the frequencies and the phases of the clocks of the electronic device 110 and the MRI device 120 after synchronization in the historical data. Training of the synchronization model may be performed using model training manners such as a gradient descent manner.

In some embodiments of the present disclosure, the clock synchronization may be implemented via a single clock synchronization manner or a combination of the plurality of clock synchronization manner, which may reflect the diversity and selectivity of the implementation of the clock synchronization. The different clock synchronization manners have their own advantages and disadvantages. For example, by arranging cables inside the MRI device 120, there is no need to install the signal receiving modules on electronic devices inside the MRI device 120, and no exposed cables will be caused, while the effect of the clock synchronization may also be achieved. However, with the increase in the count of the electronic devices 110 inside the scanning room, the existence of clock cables limits the flexibility of component layout. Therefore, the clock synchronization between the MRI device 120 and the external electronic devices of the MRI device 120 (e.g., a monitoring module for a subject, a sensing module for the subject, a hyperbaric injection module, a physiological monitoring module, a subject care module, an environmental monitoring module, a mobile controller carried by a caregiver and/or a physician, a computer carried by a caregiver and/or a physician, a cell phone carried by a caregiver and/or a physician, or the like) may be implemented via the wirelessly broadcasting wireless clock signals, thereby avoiding the cable layout outside the MRI device 120.

In some embodiments, to avoid problems such as an increase in a count of interfaces between a movable scanning bed, a control panel, or the like and the MRI device 120 caused by the use of the clock cables, as well as the heavy weight and high cost of the cables, the wireless clock signals are transmitted to the electronic device 110 located inside the scanning room 170 or entering the scanning room 170 via the wireless clock broadcasting. When the electronic device 110 enters the scanning room 170, the electronic device 110 may automatically receive the wireless clock signals broadcast in the space via the signal receiving module inside the electronic device 110, thereby achieving the synchronizing with the standard clock signals. This manner is simple and easy to implement. Via the wireless clock broadcasting, heavy cables may be removed. The connection interfaces of movable components may be simplified, and costs may be saved. This manner may also realize the automatic clock synchronization of the electronic devices inside the scanning room 170 and support more electronic devices to enter the scanning room 170.

In some embodiments of the present disclosure, by adjusting the operating frequency of the electronic device 110 located inside the scanning room 170 and/or entering the scanning room 170, the frequency of the electronic device 110 is adjusted to be outside the operating frequency of the MRI device 120, which can avoid interference caused by the electronic device 110 to the MRI device 120 and enable the electronic device 110 to support more complex and accurate diagnosis and treatment processes.

FIG. 2 is a schematic diagram illustrating of an exemplary wired clock synchronization link according to some embodiments of the present disclosure.

In some embodiments, the MRI device 120 and the electronic device 110 may be connected via a cable. As shown in FIG. 2, a clock signal is output by a standard clock source 222 and transmitted to each module inside the scanning room 170 via the cable. For example, the module inside the scanning room 170 includes a monitoring module 210, a control panel 230, a scanning bed 240, a power transmitting module 221, a safety monitoring module 223, and a signal receiving module 224 in a magnet 220, or the like.

More descriptions regarding the power transmitting module 221, the monitoring module 210, the scanning bed 240, the safety monitoring module 223, and the signal receiving module 224 may be found in the related descriptions of FIG. 1B. More descriptions regarding the standard clock source 222 may be found in the related descriptions of FIG. 1B.

The magnet 220 is a core component of the MRI device 120 configured to generate a magnetic field. The control panel 230 refers to a terminal device configured to control the MRI device 120.

FIG. 3 is a schematic diagram illustrating of an exemplary wireless clock broadcast module according to some embodiments of the present disclosure.

In some embodiments, as shown in FIG. 3, the MRI device 120 includes a wireless clock broadcast module 320. The wireless clock broadcast module 320 includes the standard clock source 222, a power amplifier 321, and a wireless transmitter 323.

The wireless clock broadcast module 320 refers to a module configured to transmit wireless clock signals. More descriptions regarding the wireless clock signals may be found in the related descriptions of FIG. 1B.

In some embodiments, the wireless clock broadcast module 320 is configured to transmit the wireless clock signals to the electronic device 110 via a wireless clock broadcast 330. More descriptions regarding the electronic device and the wireless clock broadcast may be found in the related descriptions of FIG. 1B.

The standard clock source 222 refers to a device configured to generate standard clock signals. For example, the standard clock source 222 includes but is not limited to clock generation devices such as a crystal oscillator, a semiconductor oscillator, an atomic clock, or the like.

In some embodiments, the standard clock source 222 is configured to generate the standard clock signals . For example, the standard clock signals are output via devices such as phase-locked loops or clock fan-out chips.

In some embodiments, the MRI device 120 further includes an external clock 310. The external clock 310 refers to a clock source outside the MRI device 120. For example, the external clock may include but is not limited to a clock generation device, a GPS clock, a network clock, or the like.

In some embodiments, the standard clock source 222 may be externally connected to the external clock 310. Since the external clock 310 may provide precise time signals, the precision of the external clock 310 is usually higher than that of the standard clock source 222. Via external connection to the external clock 310, the precision of the standard clock source 222 may be improved.

The power amplifier 321 refers to a device configured to enhance the signal strength of the standard clock source to ensure that the signals have sufficient power to reach the electronic device during transmission.

In some embodiments, the power amplifier 321 is configured to amplify the standard clock signals and transmit the amplified standard clock signals to the wireless transmitter 323.

The wireless transmitter 323 refers to a device configured to convert clock signals into wireless signals (e.g., electromagnetic waves, light waves, sound waves, or the like). For example, the wireless transmitter 323 includes but is not limited to an antenna, a LED, a laser transmitter, a piezoelectric ceramic, an ultrasonic transducer, or the like.

In some embodiments, the wireless transmitter 323 is configured to convert the amplified standard clock signals into the wireless clock signals.

In some embodiments, the standard clock source 222 generates the standard clock signals. The standard clock signals is amplified by the power amplifier 321 and then transmitted into the space by the wireless transmitter 323 to form the wireless clock broadcast 330.

In some embodiments, as shown in FIG. 3, the MRI device 120 may further include a modulator 322. The modulator 322 is disposed between the power amplifier 321 and the wireless transmitter 323. The dashed line in FIG. 3 indicates that the corresponding module is an optional module.

The modulator 322 refers to a device configured to perform modulation, such as amplitude modulation, frequency modulation, or phase modulation on the amplified standard clock signals to obtain good clock performance. The wireless transmitter 323 converts the modulated standard clocks into the wireless clock signals.

In some embodiments of the present disclosure, the wireless clock broadcast module has advantages such as simple deployment, low cost, low power consumption, and small size. The wireless clock broadcast module may perform clock synchronization on all electronic devices equipped with wireless clock receiving modules inside the scanning room 170, without the need to equip each station with a transmitting link and a receiving link. The wireless clock broadcast module can simplify the architecture of the MRI device, and reduce hardware and maintenance costs. The wireless clock broadcast module can also improve synchronization efficiency and accuracy.

FIG. 4 is a schematic diagram illustrating of an exemplary wireless clock receiving module according to some embodiments of the present disclosure.

In some embodiments, as shown in FIG. 4, the electronic device 110 includes a wireless clock receiving module 111. The wireless clock receiving module 111 includes a wireless receiver 111-1 and a signal amplifier 111-3.

The wireless clock receiving module 111 refers to a device configured to receive wireless clock signals and convert the wireless clock signals into standard clock signals for the electronic device 110.

In some embodiments, in response to the wireless clock receiving module 111 receiving the wireless clock broadcast, the wireless receiver 111-1 converts the wireless clock signals into the standard clock signals. The signal amplifier 111-3 amplifies the standard clock signals before supplying the amplified standard clock signals to the electronic device 110.

The wireless receiver 111-1 refers to a device configured to convert the wireless clock signals (e.g., electromagnetic waves, light waves, sound waves, or the like) into the standard clock signals. For example, the wireless receiver 111-1 may include but is not limited to an antenna, a photoelectric converter, a piezoelectric ceramic, an ultrasonic transducer, or the like.

In some embodiments, the wireless receiver 111-1 is configured to receive the wireless clock signals and perform signal conversion.

The signal amplifier 111-3 refers to a device configured to amplify the received standard clock signals and transmit the amplified standard clock signals to the electronic device 110.

In some embodiments, the signal amplifier 111-3 is configured to amplify the converted signals.

In some embodiments, as shown in FIG. 4, the wireless clock receiving module 111 may further include a demodulator 111-2. The demodulator 111-2 is disposed between the wireless receiver 111-1 and the signal amplifier 111-3.

The demodulator 111-2 refers to a device configured to restore modulated clock signals to the standard clock signals. For example, the demodulator 111-2 may restore the modulated clock signals to the standard clock signals through amplitude, frequency, phase, etc. The modulated clock signals are obtained from the wireless receiver 111-1 in the wireless clock receiving module 111.

In some embodiments, as shown in FIG. 4, the wireless clock receiving module 111 may further include a phase-locked loop 111-4. The phase-locked loop 111-4 is disposed between the signal amplifier 111-3 and the electronic device 110. The dashed line in FIG. 4 indicates that the corresponding module is an optional module.

The phase-locked loop 111-4 refers to a device configured to convert the standard clock signals into common-source clock signals with different frequencies for the electronic device 110 to use freely.

The term "common-source clock signals with different frequencies" means that two or more signals have the same phase reference and stability (e.g., the two or more signals originate from the same signal generator or clock source) but different frequency values.

In some embodiments of the present disclosure, the wireless clock receiving module also has advantages such as simple deployment, low cost, low power consumption, and small size. The electronic devices entering the scanning room 170 only need to be equipped with the wireless clock receiving module to receive the wireless clock signals transmitted by the wireless clock broadcast module, thereby achieving wireless clock synchronization and improving synchronization accuracy and efficiency.

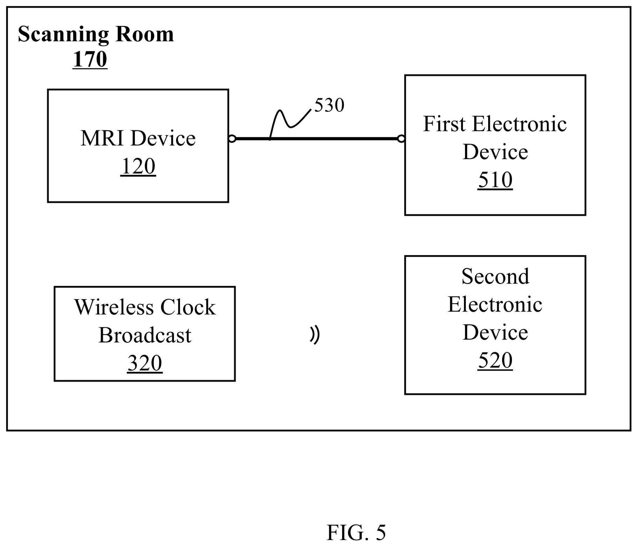

FIG. 5 is a schematic diagram illustrating of an exemplary wireless clock broadcast synchronization link according to some embodiments of the present disclosure.

In some embodiments, as shown in FIG. 5, there is the plurality of electronic devices 110 (FIG. 5 exemplifies a first electronic device 510 and a second electronic device 520, but it should be understood that the count of the electronic device may be more than two). The MRI device 120 is connected to the first electronic device 510 among the plurality of electronic devices via a cable 530. The MRI device 120 is transmitting wireless clock signals to the second electronic device 520 among the plurality of electronic devices via the wireless clock broadcast module 320. In some embodiments, the first electronic device 510 refers to an electronic device associated with magnetic resonance scanning or an electronic device close to a magnet side of the MRI device 120 (e.g., a distance less than a threshold). In some embodiments, the second electronic device 520 refers to an electronic device unrelated to the magnetic resonance scanning or a mobile electronic device. More descriptions regarding the first electronic device and the second electronic device may be found in the related descriptions of FIG. 1B.

In some embodiments, the MRI device 120 is connected to the first electronic device 510 among the plurality of electronic devices via the cable. The MRI device 120 may transmit the clock signals to the first electronic device 510 via the cable to achieve clock synchronization between the MRI device 120 and the first electronic device 510.

In some embodiments, the MRI device 120 may transmit the wireless clock signals to the second electronic device 520 via the wireless clock broadcast module 320. The wireless clock broadcasting, based on the wireless clock broadcast module 320, serves to achieve clock synchronization between the MRI device 120 and the second electronic device 520.

Via the combination of wired and wireless manners, complex cables may be avoided on some electronic devices (e.g., mobile electronic devices). Internal cable connections may be used on some magnet sides (e.g., internal components of the MRI device 120), resulting in accurate clock synchronization. For example, the magnet side uses wired connections via the cables, and the mobile device side uses wireless connections.

In some embodiments, the wireless clock signals are transmitted via carriers. Transmission via the plurality of carriers enables the wireless clock synchronization manner to be universal in different environments and usage scenarios, having universality.

FIG. 6 is a schematic diagram illustrating of an exemplary wireless clock broadcast synchronization link according to some other embodiments of the present disclosure.

In some embodiments, as shown in FIG. 6, the standard clock source 222 transmits standard clock signals into the wireless clock broadcast module 320. The standard clock signals pass through internal components of the wireless clock broadcast module 320 to generate standard clock signals. The standard clock signals are amplified by a power amplifier. The amplified standard clock signals are input to a laser generator to output infrared light signals carrying the standard clock signals for broadcasting inside the scanning room 170. A plurality of magnetic resonance signal receivers (e.g., a first magnetic resonance signal receiver 610-1, a second magnetic resonance signal receiver 610-2, etc.) placed inside a bed board of the scanning bed 240 and the monitoring module 210 placed on a wall (of the scanning room 170) receive the infrared light signals broadcast inside the scanning room 170 via a photoelectric converter inside the wireless clock receiving module, and convert the infrared light signals into clock signals. The clock signals are amplified by a signal amplifier before being output to the first magnetic resonance signal receiver 610-1, the second magnetic resonance signal receiver 610-2, and the monitoring module 210.

More descriptions regarding the monitoring module for a subject and the scanning room may be found in the related descriptions of FIG. 1B. More descriptions regarding the standard clock source, the magnet, the signal receiving module, the safety monitoring module, and the power transmitting module may be found in the related descriptions of FIG. 2. More descriptions regarding the wireless clock broadcast module may be found in the related descriptions of FIG. 3. More descriptions regarding the wireless clock receiving module, the signal amplifier, etc. may be found in the related descriptions of FIG. 4.

The magnetic resonance signal receiver refers to a device configured to receive RF signals generated by hydrogen nuclei (or other nuclides) in a sample or a subject after being excited by RF pulses. For example, the magnetic resonance signal receiver may include but is not limited to a receiving coil, a signal processor, or the like.

In some embodiments, via the aforementioned manner, automatic clock synchronization is achieved between the magnetic resonance signal receivers (e.g., the first magnetic resonance signal receiver 610-1 or the second magnetic resonance signal receiver 610-2) of the scanning bed 240 and the monitoring module 210. Simplifies the cables from the magnet side to the monitoring module 210 on the wall and the cables from inside the scanning bed 240 to the magnetic resonance signal receivers inside the bed board (e.g., the first magnetic resonance signal receiver 610-1 or the second magnetic resonance signal receiver 610-2), reducing the cost of the cables, cable deployment and cable design. Potential personal/equipment safety hazards, such as electric leakage and tripping, are avoided.

Electromagnetic waves are a wave phenomenon in which electric fields and magnetic fields are perpendicular to each other, mutually excite each other, and propagate in space in the form of waves. In some embodiments, the wireless clock signals may be transmitted via electromagnetic waves.

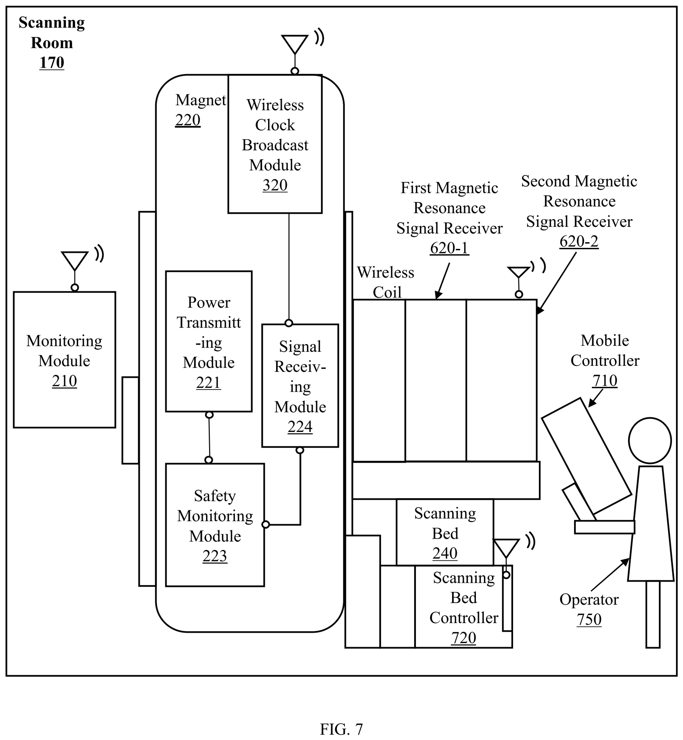

FIG. 7 is a schematic diagram illustrating of an exemplary wireless clock broadcast synchronization link according to some other embodiments of the present disclosure

In some embodiments, as shown in FIG. 7, the wireless clock broadcast module 320 has a built-in temperature-controlled crystal oscillator as a standard clock source. Standard clock signals are transmitted to the signal receiving module 224, the safety monitoring module 223, and the power transmitting module 221 on the magnet side via cables.

In some embodiments, after the standard clock signals are power-amplified, the standard clock signals enter a modulator inside the wireless clock broadcast module 320. Clock signals with electromagnetic waves (e.g., radio waves with a frequency band of 5.8 GHz, etc.) as carriers are obtained via amplitude modulation. The clock signals are transmitted to an antenna for broadcasting inside the scanning room 170.

In some embodiments, the signal receiving module 224 is disposed in magnetic resonance signal receivers (e.g., the first magnetic resonance signal receiver 610-1, the second magnetic resonance signal receiver 610-2, or the like) inside the wireless coil, the monitoring module on the wall, a scanning bed controller 720 at the bottom of the scanning bed 240, and a mobile controller 710 held by an operator 750 that is not directly connected to the MRI device 120.

In some embodiments, the signal receiving module 224 detects the clock signals with electromagnetic waves (e.g., at a frequency of 5.8 GHz) as carriers broadcast inside the scanning room 170 via the antenna. The clock signals with electromagnetic waves perform amplitude demodulation on the clock signals via a demodulator to convert the clock signals back to the standard clock signals. The standard clock signals are amplified by a signal amplifier, processed via a phase-locked loop, and finally output as common-source clock signals with different frequencies to the electronic device.

More descriptions regarding the signal receiving module, the safety monitoring module, the scanning room, and the mobile controller may be found in the related descriptions of FIG. 1B. More descriptions regarding the power transmitting module and the standard clock source may be found in the related descriptions of FIG. 1B. More descriptions regarding the wireless clock broadcast module may be found in the related descriptions of FIG. 1B. More descriptions regarding the demodulator and the signal amplifier may be found in the related descriptions of FIG. 1B.

The scanning bed controller 720 refers to a device configured to control the movement of the mobile scanning bed. For example, the scanning bed controller 720 may include but is not limited to a control template, a motor driver, or the like.

In some embodiments, via the aforementioned manner, the cables from the magnet side to the monitoring module on the wall may be simplified, reducing the cost of the cables, cable deployment, and cable design. Potential personal/equipment safety hazards, such as electric leakage and tripping, are avoided.

In some embodiments, by reducing a count of clock interfaces between the scanning bed and the magnet side, the complexity of the connection interfaces between the scanning bed 240 and the magnet side may be reduced, thereby lowering the design and deployment costs required for stable connection between the scanning bed 240 and the magnet side. Potential personal/equipment safety hazards such as electric leakage and mechanical damage are also reduced.

In some embodiments, via the aforementioned manner, automatic clock synchronization between the magnetic resonance signal receivers (e.g., the first magnetic resonance signal receiver 610-1, the second magnetic resonance signal receiver 610-2, etc.) inside the wireless coil and the mobile controller 710 held by the operator 750 with the MRI device 120 is also achieved. Since each component in the MRI device 120 avoids the limitation of cable connection. The operator is allowed to use the electronic device 110 and the mobile controller 710 freely, further improving the quality of scanned images.

Ultrasonic waves refer to sound waves with a frequency (approximately 20 KHz) higher than the upper limit of human hearing. In some embodiments, the wireless clock signals may further be transmitted via the ultrasonic waves.

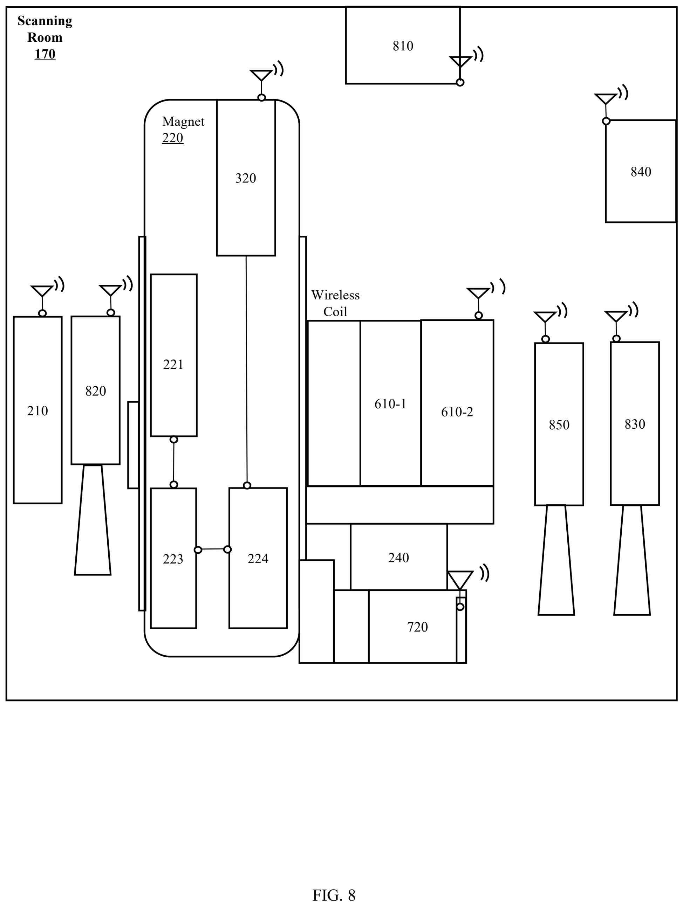

FIG. 8 is a schematic diagram illustrating of an exemplary wireless clock broadcast synchronization link according to some other embodiments of the present disclosure.

In some embodiments, as shown in FIG. 8, the wireless clock broadcast module 320 has a built-in cesium atomic clock as the standard clock source, and standard clock signals are transmitted via a cable to a signal receiving module 224, the safety monitoring module 223, and the power transmitting module 221 on the side of the magnet 220.

In some embodiments, after the standard clock signals are amplified by the power amplifier, the standard clock signals enter the ultrasonic transducer inside the wireless clock broadcast module 320 to generate ultrasonic waves carrying the standard clock signals, and the ultrasonic waves are broadcast in the scanning room 170.

In some embodiments, the signal receiving module 224 may receive signals transmitted by modules such as a magnetic resonance signal receiver 730 located inside the wireless coil, the monitoring module 210 mounted on the wall, a scanning bed controller 720 at the bottom of the scanning bed 240, a sensing module 810 at a ceiling, an environmental monitoring module 840 on an opposite wall, a hyperbaric injection module 820 for subject care that is unrelated to the MRI system, a physiological monitoring module 850, a subject care robot 830, or the like.

In some embodiments, the signal receiving module 224 detects ultrasonic waves carrying standard clock signals in the scanning room 170 via the ultrasonic transducer, converts the ultrasonic waves back into clock signals, and the clock signals pass through the signal amplifier, enter the phase-locked loop, and finally output clock signals of the same source but different frequencies required by the electronic device.

More descriptions regarding the signal receiving module, the safety monitoring module, the scanning room, and the mobile controller may be found in descriptions in connection with FIG. 1B. More descriptions regarding the power transmitting module and the standard clock source may be found in descriptions in connection with FIG. 2. More descriptions regarding the wireless clock broadcast module may be found in descriptions in connection with FIG. 3. More descriptions regarding the signal amplifier may be found in descriptions in connection with FIG. 4.

In some embodiments, by the aforementioned method, the cables from the side of the magnet 220 to the monitoring module on the wall, the sensing module 810 at the ceiling, and the environmental monitoring module 840 on the wall can be simplified. This reduces the cost of the cables themselves, the deployment and design costs of the cables, and potential safety hazards to human bodies/equipment, such as possible electric leakage and tripping, and allows more intelligent devices to enter the scanning room.

In some embodiments, by reducing the clock interfaces between the scanning bed 240 and the side of the magnet 220, the complexity of the connection interfaces between the scanning bed 240 and the side of the magnet 220 is reduced. This further reduces the design and deployment costs caused by the stable connection between the scanning bed 240 and the side of the magnet 220, as well as potential safety hazards to human bodies/equipment, such as possible electric leakage and mechanical damage.

In some embodiments, by the aforementioned method, automatic synchronization between the magnetic resonance signal receivers (e.g., the first magnetic resonance signal receiver 610-1, the second magnetic resonance signal receiver 610-2, or the like) inside the wireless coil, the hyperbaric injection module 820, the physiological monitoring module 850, the subject care robot 830, and the standard clock is also achieved. This allows more intelligent devices for subject monitoring and care to enter the scanning room 170.

In some embodiments, since various components in the MRI device 120 avoid the limitations of wireless cable connections, the impact of frequency interference and the like on MRI images can be avoided. This facilitates the use by medical staff, contributes to the treatment of subjects, and allows subjects with various physical conditions to enter the scanning room 170 for safe and effective image scanning.

In some embodiments of the present disclosure, the transmission through a plurality of carriers enables the wireless clock synchronization method to be universal in different environments and usage scenarios, thus having universality. In addition, it can reduce deployment costs and avoid potential safety hazards to human bodies/equipment, such as possible electric leakage and mechanical damage. It should be understood that FIGs. 6-8 are merely examples and do not limit specific electronic devices or specific carriers.

In some embodiments, the wireless clock signals may also be transmitted through the plurality of carriers. For example, the wireless clock signals may use at least two carriers simultaneously (e.g., at least two of infrared light, electromagnetic waves, and ultrasonic waves) for transmission to improve the accuracy of clock synchronization. In some embodiments, when the wireless clock signals are transmitted through the plurality of carriers, the wireless clock signals may be processed by the phase-locked loop capable of processing the plurality of carriers simultaneously.

In some embodiments, the plurality of receivers or transmitters may be integrated on the MRI device 120, the electronic device 110, or the anti-interference device 160 for transmitting/receiving different carriers. In some embodiments, the carrier selector may also be installed on the MRI device 120, the electronic device 110, or the anti-interference device 160 simultaneously, and the carrier selector is configured to intelligently select the suitable carrier for clock synchronization. The carrier selector may intelligently select the carrier for clock synchronization based on MRI scanning scenarios (e.g., environmental characteristics in the scanning room, penetration capability of the carrier, anti-interference capability of the carrier, timeliness requirements, or the like). For example, for application scenarios where the distance to the MRI device 120 is relatively short and real-time frequency adjustment is required, infrared light is preferentially selected as the carrier for clock synchronization. While for usage scenarios where there are bright lighting sources, many obstacles, or relatively humid air in the scanning room, infrared light needs to be avoided, and electromagnetic waves are preferentially selected as the carrier for clock synchronization.

In some embodiments, the MRI device 120 (or the processor 130) may also intelligently select the carrier for clock synchronization based on a carrier selection model. The carrier selection model may be a machine learning model. In some embodiments, an input of the carrier selection model includes environmental data in the scanning room and scanning parts, and an output includes the carrier of the clock signals. In some embodiments, the training samples of the carrier selection model include environmental data in the scanning room and scanning parts during historical MRI scanning processes, and the labels include the carriers of the clock signals during the historical MRI scanning processes. The labels may be obtained through manual annotation, and the training method may adopt a gradient descent method or the like.

In some embodiments of the present disclosure, intelligently selecting the carrier of the clock signals can effectively reduce interference, and achieve efficient and accurate clock synchronization between the MRI device and the electronic device.

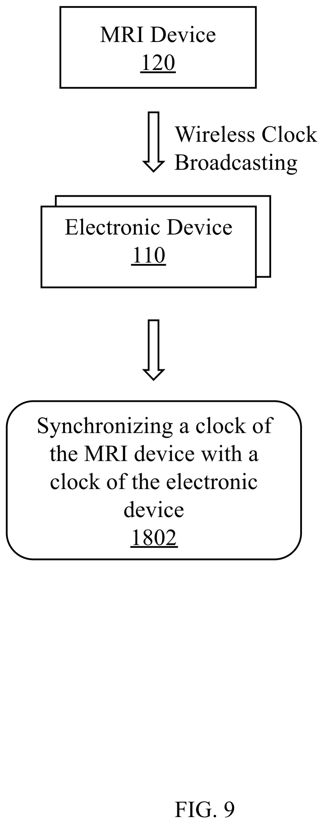

FIG. 9 is a schematic diagram illustrating of an exemplary magnetic resonance imaging (MRI) method according to some other embodiments of the present disclosure.

In some embodiments, as shown in FIG. 9, the MRI device 120 synchronizes the clock of the electronic device 110 located inside the scanning room 170 and/or entering into the scanning room 170 with the clock of the MRI device 120 via wireless clock broadcasting (1802). In some embodiments, the MRI method may be implemented by the MRI device 120 or the processor 130.

In the present embodiment, for any electronic device 110 that enters the scanning room 170 or is already inside the scanning room 170, the operating frequency of the electronic device 110 is adjusted to be outside an operating frequency of the MRI device 120, to enable both the electronic device 110 and the MRI device 120 to operate normally without interfering with each other. The electronic device 110 can support complex and accurate diagnosis and treatment processes.

In some embodiments, when there is the plurality of electronic devices 110, synchronizing the clock of the electronic device 110 located inside the scanning room 170 and/or entering into the scanning room 170 with the clock of the MRI device 120 via wireless clock broadcasting includes: transmitting wireless clock signals to each of the plurality of electronic devices 110 separately and unidirectionally in the one-to-many manner via the wireless clock broadcasting.

In some embodiments, the wireless clock signals are configured to synchronize the first clock frequency of the electronic device 110 with the second clock frequency of the MRI device 120.

In some embodiments, the wireless clock signals are not configured to synchronize the first clock phase of the electronic device 110 with the second clock phase of the MRI device 120.

In some embodiments, synchronizing the clock of the MRI device 120 with the clock of the electronic device 110 includes at least one of the following: broadcasting, by the MRI device 120, infrared light carrying standard clock signals in the scanning room 170; broadcasting, by the MRI device 120, electromagnetic waves carrying standard clock signals in the scanning room 170; or broadcasting, by the MRI device 120, ultrasonic waves carrying standard clock signals in the scanning room 170.

The MRI method as shown in FIG. 9 is similar to the MRI method described above. For specific details, reference may be made to the relevant parts described above (e.g., descriptions in connection with FIGs. 1B ~8, or the like).

Embodiments of the present disclosure further provide a MRI device, which is configured to: adjusting an operating frequency of at least one electronic device located inside a scanning room and/or entering into the scanning room, or synchronizing the clock of the electronic device located inside the scanning room and/or entering into the scanning room with the clock of the MRI device. The adjusted frequency of the electronic device is outside the operating frequency of the MRI device

In some embodiments, the adjusting the operating frequency of the electronic device includes synchronizing the clock of the MRI device with the clock of the electronic device. The MRI device includes a wireless clock broadcast module. The wireless clock broadcast module is configured to transmit wireless clock signals to the electronic device via wireless clock broadcasting. The wireless clock broadcast module includes a standard clock source, a power amplifier, and a wireless transmitter. The standard clock source is configured to generate the standard clock signals. The power amplifier is configured to amplify the standard clock signals and transmit the amplified standard clock signals to the wireless transmitter. The wireless transmitter is configured to convert the amplified standard clock signals into the wireless clock signals. The standard clock source, the power amplifier, and the wireless transmitter are all disposed within the wireless clock broadcasting module.

The wireless clock broadcast module is simple to deploy, low in cost, low in power consumption, and small in size. The wireless clock broadcast module can perform clock synchronization for all devices equipped with the wireless clock receiving module in the scanning room, without the need to equip each station with both a transmitting link and a receiving link.

In some embodiments, the electronic device includes the wireless clock receiving module, and the wireless clock receiving module includes the wireless receiver and the signal amplifier. The wireless receiver is configured to receive the wireless clock signals and perform signal conversion. The signal amplifier is configured to amplify the converted signals.

The wireless clock receiving module is simple to deploy, low in cost, low in power consumption, and small in size. The electronic device entering the scanning room only needs to be equipped with the wireless clock receiving module to receive the clock signals sent by the wireless clock broadcast module, thereby achieving wireless clock synchronization.

In some embodiments, more descriptions regarding the electronic device can be found elsewhere (e.g., FIG. 1A) in the present application.

Embodiments of the present disclosure further provide an anti-interference device. The anti-interference device is removably mounted on an electronic device located inside the scanning room and/or entering into the scanning room (e.g., via an interface). In some embodiments, the anti-interference device is configured to adjust an operating frequency of the electronic device located inside the scanning room and/or entering into the scanning room. In some embodiments, the anti-interference device is configured to synchronize the clock of the electronic device located inside the scanning room and/or entering into the scanning room with the clock of the MRI device. The adjusted frequency of the electronic device is outside the operating frequency of the MRI device.

In some embodiments, the anti-interference device includes the wireless clock receiving module. The wireless clock receiving module includes the wireless receiver and the signal amplifier. The wireless receiver is configured to receive wireless clock signals inside the scanning room and perform signal conversion. The signal amplifier is configured to amplify the converted signals.

In some embodiments, the adjusting the clock of the electronic device includes synchronizing the clock of the MRI device with the clock of the electronic device. The MRI device includes the wireless clock broadcast module, and the wireless clock broadcast module is configured to transmit wireless clock signals to the anti-interference device via wireless clock broadcasting. The wireless clock broadcast module includes the standard clock source, the power amplifier, and the wireless transmitter. The standard clock source is configured to generate the standard clock signals. The power amplifier is configured to amplify the standard clock signals and transmit the amplified standard clock signals to the wireless transmitter. The wireless transmitter is configured to convert the amplified standard clock signals into the wireless clock signals.

FIG. 10 is a flowchart of an exemplary process for wireless clock synchronization according to some embodiments of the present disclosure. As shown in FIG. 10, the process 1000 includes the following operations. In some embodiments, the process 1000 may be implemented by a MRI device.

In 1010, the wireless clock broadcast module performs wireless clock broadcasting of a standard clock.

In some embodiments, the wireless clock broadcast module performs wireless clock broadcasting of the standard clock by an external clock and/or the standard clock source to generate standard clock signals. This ensures that the carrier carrying the standard clock signals propagates inside the scanning room 170, so that the standard clock signals can be received throughout the scanning room 170.

In 1020, an electronic device equipped with a wireless clock receiving module enters the scanning room.

In some embodiments, the wireless clock receiving module integrated on the electronic device 110 is in a standby state, ready to receive signals from the wireless clock broadcast module. In some embodiments, when the electronic device 110 enters the scanning room 170, the anti-interference device 160 is mounted on electronic device 110 (e.g., via an interface). The anti-interference device 160 is configured to receive signals from the wireless clock broadcast module.

In 1030, the wireless clock receiving module receives the wireless broadcast.

In some embodiments, in response to the wireless clock receiving module capturing the wireless clock broadcast signals in the scanning room 170, components inside the wireless clock receiving module perform processing such as amplification, frequency conversion, or the like on the signals, and convert the signals into a signal form suitable for subsequent processing.

In 1040, the wireless clock receiving module outputs the standard clock.

In some embodiments, after signal processing, the wireless clock receiving module locks the received signals through technologies such as a phase-locked loop to ensure that the frequency of the output signals is of the same source as the broadcast clock signals. The phase-locked loop adjusts an oscillator inside the wireless clock receiving module to make its frequency match the broadcast standard clock signals, and outputs the stable and accurate standard clock signal, which can be used by an internal clock system of the electronic device.

In 1050, the electronic device completes clock synchronization with the standard clock.

In some embodiments, the internal clock system of the electronic device 110 receives standard clock signals output by the wireless clock receiving module, and the clock synchronization algorithm of the electronic device 110 is performed. The internal clock system of the electronic device 110 compares the internal clock with the received standard clock signals and makes necessary adjustments.

In some embodiments, the adjustments may include changing the frequency of the internal clock or directly replacing signals of the internal clock, so as to ensure that the clock of the electronic device is completely synchronized with the clock of a wireless clock broadcast module. Once the synchronization is completed, the electronic device may rely on the accurate time reference to perform various time-sensitive operations, such as data acquisition, processing, and storage during magnetic resonance scanning.

In some embodiments of the present disclosure, frequency adjustment is implemented by means of clock synchronization, which may ensure that the electronic device 110 inside the scanning room 170 operates within the predetermined frequency range. This not only avoids conflicts with a Larmor precession frequency of collected nuclides, but also ensures that only natural background noise, without external noise, exists within a frequency bandwidth of the collected nuclides. That is, the above-described process not only achieves time synchronization of all electronic devices 110 inside the scanning room 170, but also effectively eliminates external noise sources that may affect nuclide signals through frequency planning, thereby ensuring accuracy and reliability of scanning.

In some embodiments, clock synchronization of various electronic devices is implemented by converting wired clock signals into wireless clock signals and broadcasting the wireless clock signals inside the scanning room 170. This may remove heavy RF cables, simplify connection interfaces of movable components, and thus reduce costs. Meanwhile, automatic synchronization of devices inside the scanning room 170 may simplify an integration process of intelligent products.

Beneficial effects that may be brought by the embodiments of the present disclosure include: (1) The frequency of the electronic device is adjusted by means of clock synchronization, so that a plurality of types of electronic devices can enter the scanning room without affecting image quality of magnetic resonance scanning and diagnostic results, thereby providing intelligent and diversified functions for the magnetic resonance scanning process. (2) The above-described process may eliminate complex algorithms and tedious adjustment processes, that is, no dedicated computing device needs to be equipped. This not only significantly reduces costs, but also remarkably reduces sizes and power consumptions of the wireless clock broadcast module and the wireless clock receiving module, thereby improving cost-effectiveness and energy efficiency of the MRI device. (3) A high degree of automation enables the electronic device to complete synchronization with the standard clock automatically only by being placed inside the scanning room, without performing any configuration, communication, or operation when entering the scanning room, which greatly simplifies an operation process and improves synchronization efficiency. (4) Only one wireless clock broadcast module is needed to achieve clock synchronization of all devices equipped with the wireless clock receiving module inside the scanning room, which eliminates the need to install transmitting and receiving links at each device, thereby reducing complexity and costs of the MRI system.

The basic concepts have been described above, and it is apparent to a person skilled in the art that the above detailed disclosure is intended only as an example and does not constitute a limitation of the present disclosure. While not expressly stated herein, various modifications, improvements, and amendments may be made to this disclosure by those skilled in the art. Those types of modifications, improvements, and amendments are suggested in this disclosure, so those types of modifications, improvements, and amendments remain within the spirit and scope of the exemplary embodiments of this disclosure.

## Claims

1. A magnetic resonance imaging (MRI) method, comprising:
adjusting an operating frequency of at least one electronic device located inside a scanning room or entering into the scanning room, wherein an adjusted frequency of the electronic device is outside an operating frequency of a magnetic resonance imaging device.

2. The MRI method according to claim 1, wherein the adjusting the operating frequency of the electronic device located inside the scanning room or entering into the scanning room includes: synchronizing a clock of the electronic device with a clock of the magnetic resonance imaging device, and the synchronizing the clock of the electronic device with the clock of the magnetic resonance imaging device includes at least one of:
the magnetic resonance imaging device and the electronic device being connected via a cable; or
wireless clock signals being transmitted to the electronic device via wireless clock broadcasting.

3. The MRI method according to claim 2, wherein when there is a plurality of electronic devices the transmitting the wireless clock signals to the electronic device via wireless clock broadcasting includes:
transmitting the wireless clock signals to each of the plurality of electronic devices separately and unidirectionally in a one-to-many manner via the wireless clock broadcasting.

4. The MRI method according to claim 2 or 3, wherein the wireless clock signals are configured to synchronize a first clock frequency of the electronic device with a second clock frequency of the magnetic resonance imaging device.

5. The MRI method according to any one of claims 2-4, wherein the wireless clock signals are configured that a first clock phase of the electronic device does not synchronize with a second clock phase of the magnetic resonance imaging device.

6. The method according to any one of claims 2-5, wherein the wireless clock signals are transmitted through a carrier, the carrier including at least one of infrared light, electromagnetic waves, or ultrasonic waves.

7. The MRI method according to claim 6, wherein the synchronizing the clock of the electronic device with the clock of the magnetic resonance imaging device includes:
the magnetic resonance imaging device being connected to a first electronic device of the plurality of the electronic devices via a cable, and the wireless clock signals being transmitted to a second electronic device of the plurality of the electronic devices via the wireless clock broadcasting.

8. The MRI method according to claim 7, wherein the wireless clock signals are transmitted via the infrared light, and the synchronizing the clock of the electronic device with the clock of the magnetic resonance imaging device includes:
broadcasting, by the magnetic resonance imaging device, the infrared light carrying standard clock signals in the scanning room.

9. The MRI method according to claim 7 or 8, wherein the wireless clock signals are transmitted via the electromagnetic waves, and the synchronizing the clock of the electronic device with the clock of the magnetic resonance imaging device includes:
broadcasting, by the magnetic resonance imaging device, the electromagnetic waves carrying standard clock signals in the scanning room.

10. The MRI method according to any one of claims 7-9, wherein the wireless clock signals are transmitted via the ultrasonic waves, and the synchronizing the clock of the electronic device with the clock of the magnetic resonance imaging device includes:
broadcasting, by the magnetic resonance imaging device, the ultrasonic waves carrying standard clock signals in the scanning room.

11. A magnetic resonance imaging (MRI) device, configured to perform a method according to any one of claims 1-10.

12. The MRI device according to claim 11, wherein the adjusting the operating frequency of the electronic device includes synchronizing a clock of the electronic device with a clock of the magnetic resonance imaging device, and the magnetic resonance imaging device includes a wireless clock broadcast module, the wireless clock broadcast module is configured to transmit wireless clock signals to the electronic device via wireless clock broadcast;
the wireless clock broadcast module includes a standard clock source, a power amplifier, and a wireless transmitter;
the standard clock source is configured to generate standard clock signals;
the power amplifier is configured to amplify the standard clock signals and transmit the amplified standard clock signals to the wireless transmitter; and
the wireless transmitter is configured to convert amplified standard clock signals into the wireless clock signals.

13. The MRI device according to claim 12, wherein the electronic device includes a wireless clock receiving module, and the wireless clock receiving module includes a wireless receiver and a signal amplifier;
the wireless receiver is configured to receive the wireless clock signals and perform a signal conversion to obtain converted signals; and
the signal amplifier is configured to amplify the converted signals.

14. The MRI device according to claim 13, wherein the electronic device includes a first electronic device associated with magnetic resonance scanning, the first electronic device including at least one of a wireless coil, a scanning bed, a power transmitting module, a signal receiving module, or a safety monitoring module; or
the electronic device includes a second electronic device unrelated to the magnetic resonance scanning, the second electronic device including at least one of a monitoring module for a subject, a sensing module for the subject, a hyperbaric injection module, a physiological monitoring module, a subject care module, an environmental monitoring module, a mobile controller carried by a caregiver and/or a physician, a computer carried by a caregiver and/or a physician, or a cell phone carried by a caregiver and/or a physician.

15. An anti-interference device, removably mounted on an electronic device located inside a scanning room and/or entering into the scanning room, wherein the anti-interference device is configured to:
adjusting an operating frequency of at least one electronic device located inside a scanning room or entering into the scanning room, an adjusted frequency of the electronic device is outside an operating frequency of a magnetic resonance imaging device; or
synchronizing a clock of an electronic device located inside the scanning room and/or entering into the scanning room with a clock of the magnetic resonance imaging device.
